# EUROPEAN PATENT APPLICATION

(11) **EP 4 184 246 A1**
(43) Date of publication of application: **24.05.2023**
(21) Application number: 21862034.2
(22) Date of filing: 24.08.2021
(51) Int. Cl.: G03F 7/039, G03F 7/023, C08G 73/10, C08K 5/00, C08K 5/13

(54) **POSITIVE PHOTOSENSITIVE RESIN COMPOSITION**

(30) Priority: 24.08.2020 KR 20200106238
(71) Applicant: Dongjin Semichem Co., Ltd, Incheon 22824 (KR)
(72) Inventor: YOUN, Hyoc Min, Hwaseong-si, Gyeonggi-do 18635 (KR); YEO, Tai Hoon, Hwaseong-si, Gyeonggi-do 18635 (KR); KIM, Dong Myung, Hwaseong-si, Gyeonggi-do 18635 (KR); PARK, Ah Rum, Hwaseong-si, Gyeonggi-do 18635 (KR); JANG, Gun Seok, Hwaseong-si, Gyeonggi-do 18635 (KR); LEE, Seok Hyun, Hwaseong-si, Gyeonggi-do 18635 (KR); OH, Nu Ri, Hwaseong-si, Gyeonggi-do 18635 (KR); SONG, In Ho, Hwaseong-si, Gyeonggi-do 18635 (KR); LEE, Sun Hee, Hwaseong-si, Gyeonggi-do 18635 (KR)
(74) Representative: Grünecker Patent- und Rechtsanwälte PartG mbB
(86) International application number: PCT/KR2021/011301
(87) International publication number: WO 2022/045737

(57) **Abstract**

The present disclosure relates to a positive photosensitive resin composition and, more specifically, to a positive photosensitive resin composition comprising an alkali-soluble polymer resin comprising a polyimide precursor comprising a specific chemical structure; a quinone diazide compound; and a solvent. The positive photosensitive resin composition is a suitable matter for next-generation flexible displays and semiconductor packages.

## Description

### Technical Field

This application is an application claiming priority to Korean Patent Application No. 10-2020-0106238, filed on August 24, 2020, and all contents disclosed in the specification and drawings of the application are incorporated herein by reference.

The present disclosure relates to a positive photosensitive resin composition, and more particularly, to a photosensitive resin composition that can be used for flexible displays and semiconductor package materials.

### Background Art

An organic light-emitting display (OLED) is attracting attention due to its excellent resolution. The advantage of an OLED is that unlike an LCD, an OLED does not require a backlight because the device is self-illuminating, and accordingly, an OLED can be thinned, is light in weight, and provides clear readability even outdoors. Since an OLED does not use a backlight method, a black screen can be implemented by turning off the device, so the contrast ratio and color reproduction are very good. In particular, an OLED can realize real black color compared to an LCD.

Recently, a flexible display that can be folded or bent like paper, out of the conventional hard and flat display, has attracted attention.

However, the current flexible display technology has difficulties in realizing a high-resolution display such as a flat panel display due to a sharp decrease in durability caused by cracking of pixels when the display is folded.

In addition, in the case of recent semiconductor package technology, the development of materials with high flexibility is required to alleviate stress in the multilayer structure.

### Disclosure

### Technical Problem

An objective of the present disclosure is to provide a photosensitive resin composition having excellent sensitivity, excellent durability even when the OLED device is folded, and high OLED reliability.

In addition, another objective of the present disclosure is to provide a photosensitive resin composition that has excellent flexibility and can withstand stress in a semiconductor package laminated structure.

### Technical Solution

In order to achieve the above objective, the photosensitive resin, according to an embodiment of the present disclosure, provided is a positive type photosensitive resin composition including an alkali-soluble polymer resin containing repeating units represented by Chemical Formulae 1 and 2 below as a main chain, a quinone diazide compound, and a solvent.

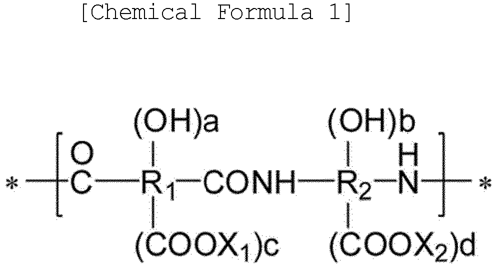

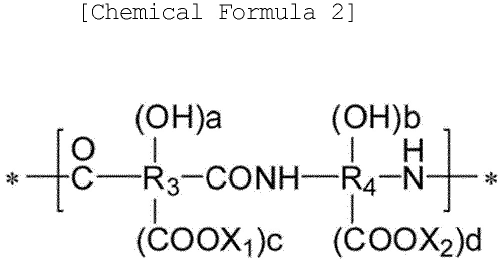

In the Chemical Formulae 1 to 2, R₂, R₂, R₃, and R₄ are each independently an organic group having 5 to 60 carbon atoms, and X₂ and X₂ are each independently hydrogen and an alkyl group having 1 to 10 carbon atoms, a and b are each independently an integer in a range of 0 to 4, c and d are each independently an integer in a range of 0 to 2, a + b is 1 or more, and when a, b, c, or d is 0, the corresponding substituent is H. At least one of R₃ and R₄ includes a structure represented by General Formula 1 below, and 5 to 70 mol% of 100 mol% of R₁ to R₄ includes a structure represented by General Formula 1 below.

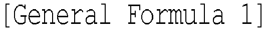

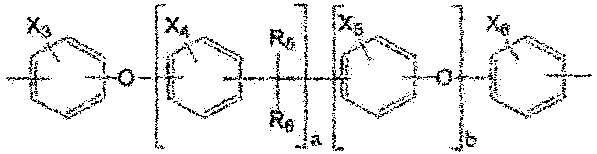

In General Formula 1, a and b are each independently an integer in a range of 0 to 10, X₃ to X₆ are each independently hydrogen or a monovalent organic group having 1 to 5 carbon atoms, and R₅ and R₆ are each independently a monovalent organic group having 1 to 10 carbon atoms.

In General Formula 1, a and b may each independently an integer in a range of 0 to 3.

The alkali-soluble polymer resin may further include repeating units represented by Chemical Formulae 3 to 4 below.

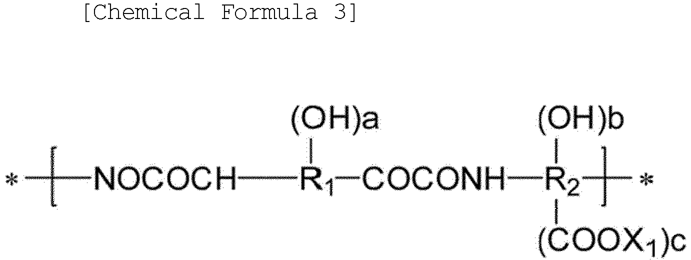

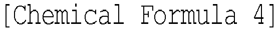

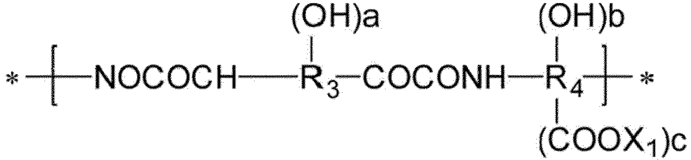

In the Chemical Formulae 3 to 4, R₁, R₂, R₃, and R₄ are each independently an organic group having 5 to 60 carbon atoms, X₁ is each independently hydrogen or an alkyl group having 1 to 10 carbon atoms, a and b are each independently an integer in a range of 0 to 4, c is each independently an integer in a range of to 2, a + b is 1 or more, and when a, b, and c are 0, the corresponding substituent is H. At least one of R₃ and R₄ includes a structure represented by General Formula 1, and 5 to 70 mol% of 100 mol% of R₁ to R₄ includes a structure represented by General Formula 1.

51 mol% or more of 100 mol% of repeating units represented by Chemical Formulae 1 to 4 included in the alkali-soluble polymer resin may have repeating units represented by Chemical Formulae 3 to 4.

40 to 70 mol% of 100 mol% of R₁ to R₄ included in the repeating units represented by Chemical Formulae 1 to 4 included in the alkali-soluble polymer resin may have a structure represented by General Formula 1.

The positive photosensitive resin composition may include 5 to 50 parts by weight of the quinone diazide compound and 100 to 2,000 parts by weight of the solvent, based on 100 parts by weight of the alkali-soluble polymer resin.

In the alkali-soluble polymer resin, R₃ and R₄ may include a structure represented by General Formula 1 above.

R₄ is a structure derived from any one of the structures represented by Chemical Formulae 5 to 14, and R₃ may be a structure derived from any one of the structures represented by Chemical Formulae 15 to 21 below.

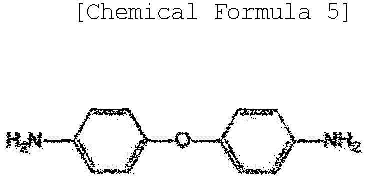

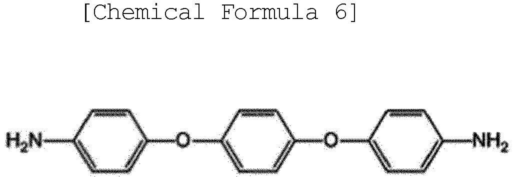

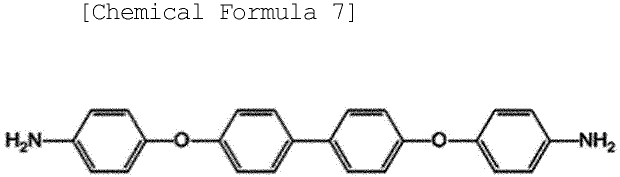

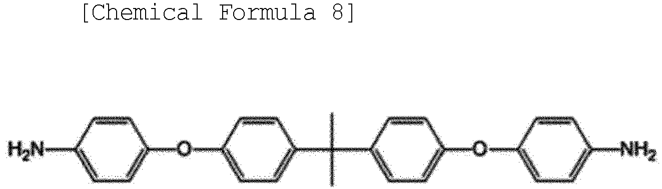

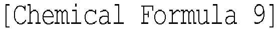

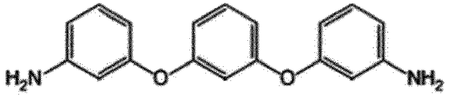

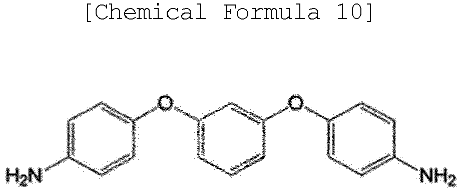

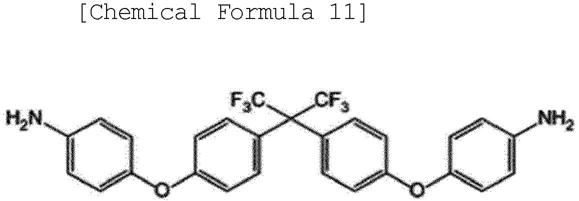

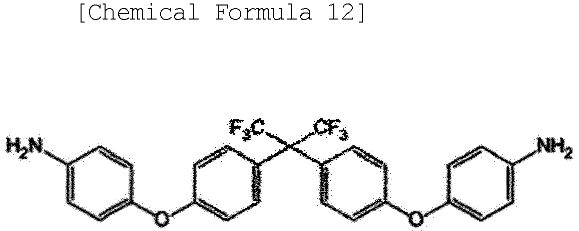

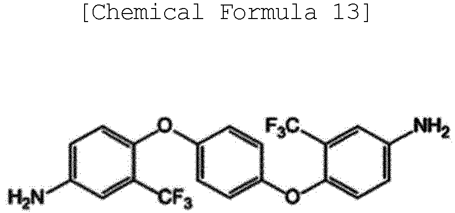

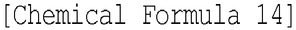

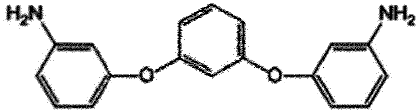

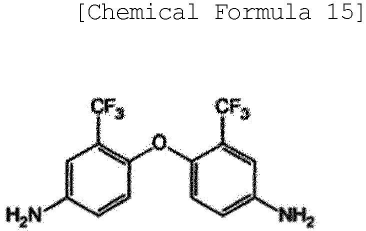

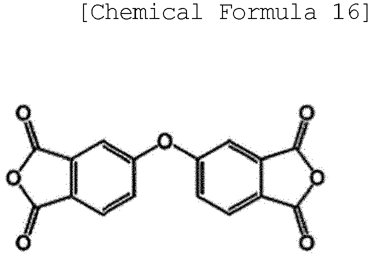

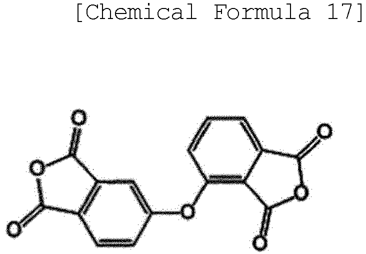

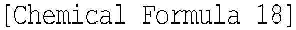

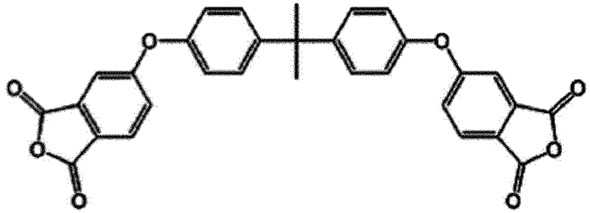

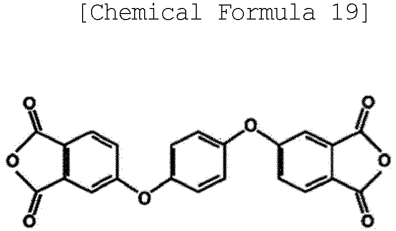

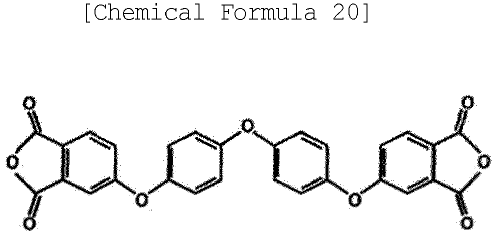

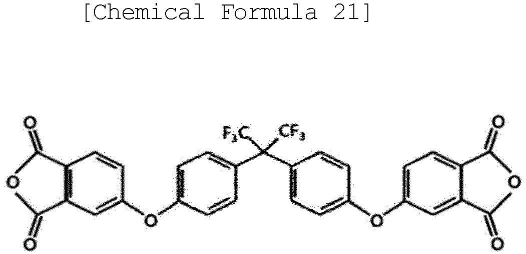

The quinone diazide compound may be obtained by reacting a naphthoquinone diazide sulfonic acid halogen compound with a phenolic compound selected from the group consisting of compounds represented by Chemical Formulae a to h below.

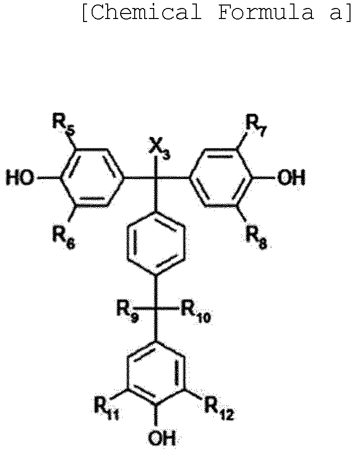

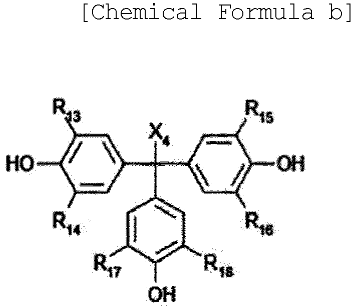

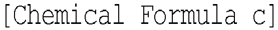

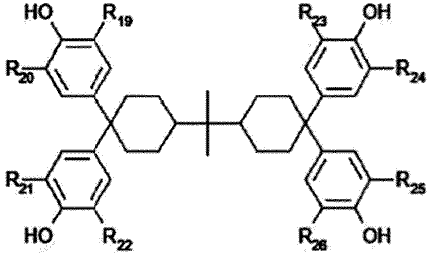

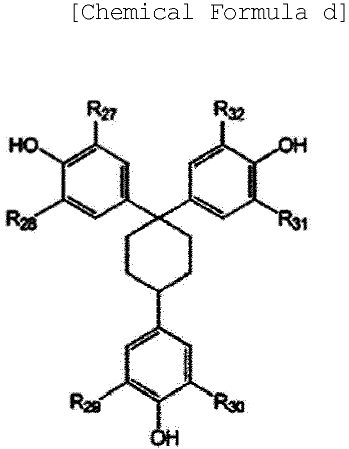

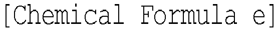

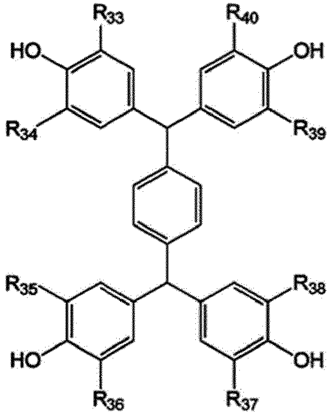

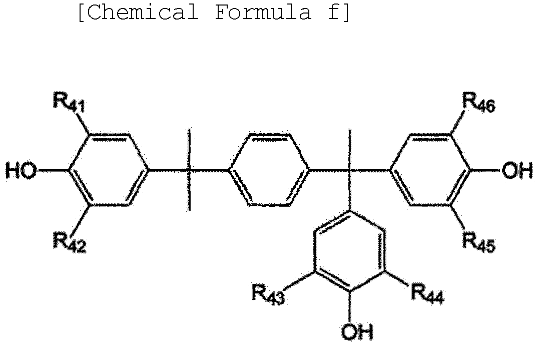

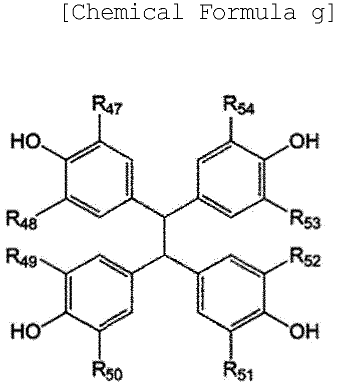

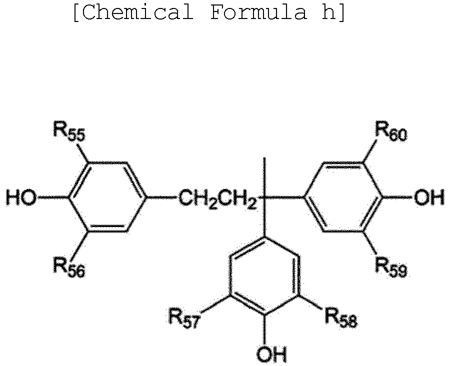

In the Chemical Formulae a to h, R₅ to R₈ and R₁₁ to R₆₀ are each independently hydrogen, halogen, a hydroxyl group, an alkyl group having 1 to 4 carbon atoms, or an alkenyl group having 2 to 4 carbon atoms, X₃ and X₄ are each independently hydrogen, halogen, or an alkyl group having 1 to 4 carbon atoms, and R₉ and R₁₀ are each independently hydrogen or an alkyl group having 1 to 4 carbon atoms.

The solvent may be at least one selected from the group consisting of gamma butyrolactone (GBL), N-methylpyrrolidone (NMP), propyleneglycolmethylether acetate (PGMEA), ethyl lactate (EL), methyl-3-methoxypropionate (MMP), propyleneglycolmonomethyl ether (PGME), diethylglycolethylmethyl ether (MEDG), diethylglycolbutylmethyl ether (MBDG), diethyleneglycoldimethyl ester (DMDG), diethyleneglycoldiethyl ester (DEDG), and a mixture thereof.

The photosensitive resin composition may further include a thermal cross-linking agent having a functional group represented by Chemical Formula 22 below.

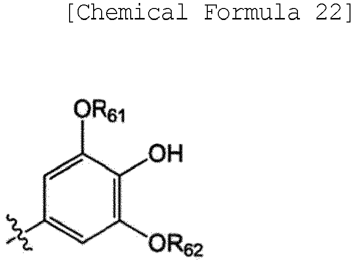

In the Chemical Formula 22, R₆₁ and R₆₂ are each independently a monovalent organic group having 1 to 5 carbon atoms.

The thermal cross-linking agent may be any one of the compounds represented by Chemical Formulae i to n.

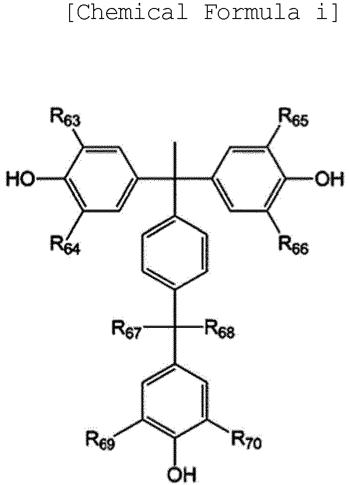

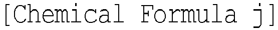

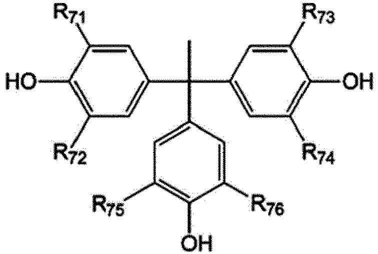

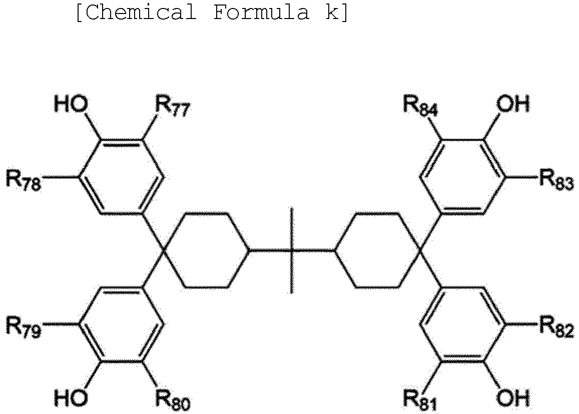

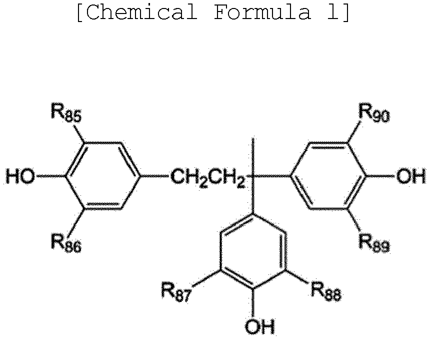

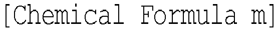

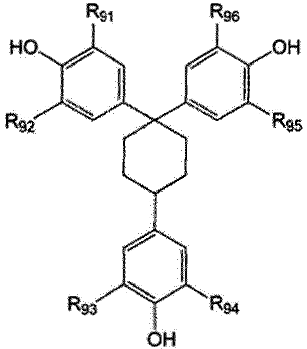

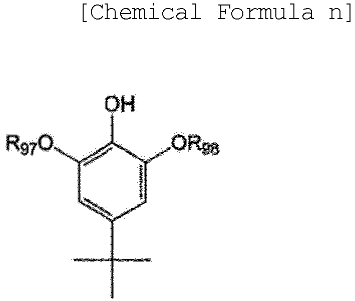

In the Chemical Formulae i to n, R₆₃ to R₉₈ are each independently a monovalent organic group having 1 to 5 carbon atoms.

Based on 100 parts by weight of the alkali-soluble polymer resin, 5 to 50 parts by weight of the thermal crosslinking agent may be included.

A cured body, according to another embodiment of the present disclosure, is obtained by curing the photosensitive resin composition.

A display device, according to still another embodiment of the present disclosure, includes the cured body as an insulating layer.

A semiconductor package device, according to still another embodiment of the present disclosure, includes the cured body as an insulating layer.

### Advantageous Effects

The positive photosensitive resin composition of the present disclosure has excellent sensitivity, excellent durability, chemical resistance, and adhesive strength even when the OLED device is folded, and also has high OLED reliability, making the positive photosensitive resin composition suitable as a next-generation flexible display material.

### Description of Drawings

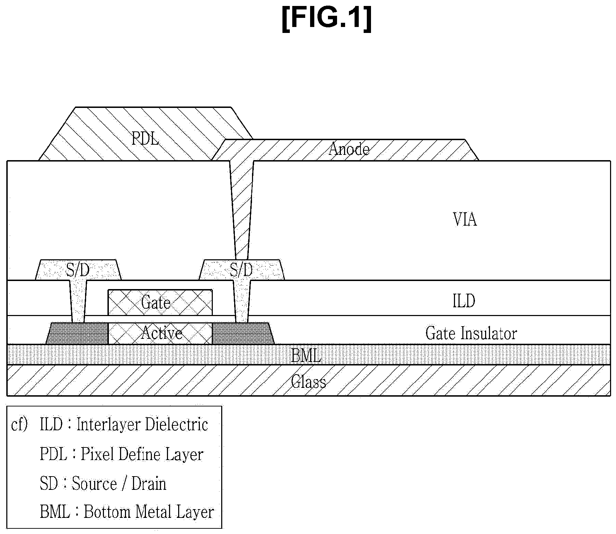

FIG. 1 is a schematic diagram showing a display structure to which a photosensitive resin composition, according to an embodiment of the present disclosure, is applied.

### Best Mode

Hereinafter, the present disclosure will be described in detail with reference to the drawings.

Prior to giving the following detailed description of the present disclosure, it should be noted that the terms and words used in the specification and the claims should not be construed as being limited to ordinary meanings or dictionary definitions but should be construed in a sense and concept consistent with the technical idea of the present disclosure, on the basis that the inventor can properly define the concept of a term to describe its disclosure in the best way possible.

Therefore, since the configurations described in the embodiments described herein are only the most preferred embodiments of the present disclosure and do not represent all the technical ideas of the present disclosure, it should be understood that there may be various equivalents and modifications that may replace them at the time of the present application.

The present disclosure relates to a positive photosensitive resin composition, which is an embodiment of the present disclosure, in which the positive photosensitive resin composition includes an alkali-soluble polymer resin including all repeating units represented by the following Chemical Formulae 1 to 2 as a main chain, quinone diazide compound, and a solvent.

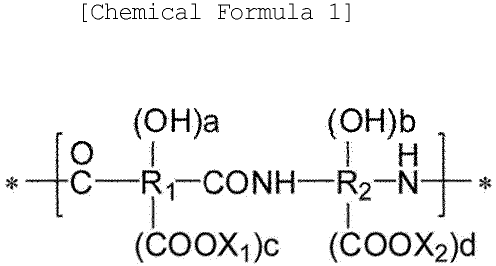

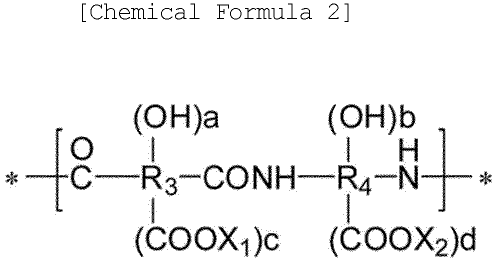

In the Chemical Formulae 1 to 2, R₁, R₂, R₃, and R₄ are each independently an organic group having 5 to 60 carbon atoms, X₁ and X₂ is each independently hydrogen or an alkyl group having 1 to 10 carbon atoms, a and b are each independently an integer in a range of 0 to 4, c and d are each independently an integer in a range of 0 to 2, a + b is 1 or more, and when a, b, and c are 0, the corresponding substituent is H. At least one of R₃ and R₄ includes a structure represented by General Formula 1, and 5 to 70 mol% of 100 mol% of R₁ to R₄ includes a structure represented by General Formula 1 below.

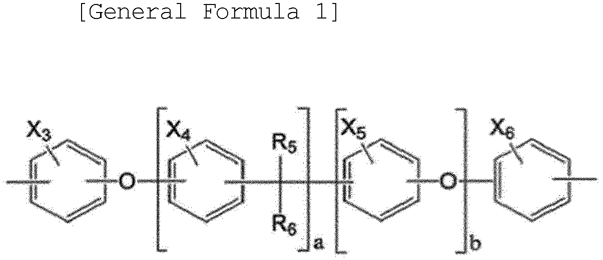

At this time, in the General Formula 1, a and b are each independently an integer in a range of 0 to 10, more specifically 0 to 3, the X₃ to X₆ are each independently hydrogen or a monovalent organic group having 1 to 5 carbon atoms, and the R₅ and R₆ are each independently a monovalent organic group having 1 to 10 carbon atoms.

Among the hydrogens contained in the organic group having 5 to 60 carbon atoms included in the alkali-soluble polymer resin, one or more hydrogens may be substituted with one of a hydroxyl group (OH), a methyl group (CH₃), and fluorine (F). The organic group having 5 to 60 carbon atoms included in the alkali-soluble polymer resin may include a methylene group, and one or more methylene groups may be substituted with one of oxygen or nitrogen. When the methylene group is substituted with nitrogen, the remaining electron of nitrogen may be covalently bonded to hydrogen.

Specifically, 40 to 70 mol% of 100 mol% of R₁ to R₄ included in repeating units represented by Chemical Formulae 1 to 4 included in the alkali-soluble polymer resin of the positive photosensitive resin composition may have a structure represented by the General Formula 1. When the alkali-soluble polymer resin is not included in the corresponding content, folding characteristics when the photosensitive resin composition is cured may be degraded, and thus flexibility may be greatly reduced.

The positive photosensitive resin composition may specifically include 5 to 50 parts by weight of a quinone diazide compound and 100 to 2,000 parts by weight of a solvent based on 100 parts by weight of the alkali-soluble polymer resin.

More specifically, the positive photosensitive resin composition may be an alkali-soluble polymer resin including a repeating unit represented by the following General Formula 1. A, B, C, and D of the following General Formula 1 of the alkali-soluble polymer resin may be one of the repeating units represented by the following Chemical Formulae 1 to 4, for example, repeating units represented by the following Chemical Formulae 1 to 4 may all be included.

Specifically, the positive photosensitive resin composition may include 51 to 100 mol% of polyimide repeating units represented by Chemical Formulae 3 and 4 below among 100 mol% of repeating units represented by Chemical Formulae 1 to 4 included in the alkali-soluble polymer resin, and more specifically, 0 to 49 mol% of polyamic acid or polyamic ester repeating units represented by Chemical Formulae 1 and 2 below. More specifically, the positive photosensitive resin composition may include the repeating unit represented by Chemic Formula 2 or Chemical Formula 4 in an amount of 5 mol% or more and 70 mol% or less. When the polyimide repeating units represented by Chemical Formulae 3 and 4 are 50 mol% or less among 100 mol% of repeating units represented by Chemical Formulae 1 to 4 included in the alkali-soluble polymer resin, chemical resistance, and OLED drive reliability are deteriorated.

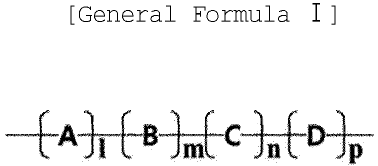

In the General Formula I, l, m, n, and p are each independently an integer of 0 to 25, when l, m, n, and p are 0, it means that the corresponding structure is not included.

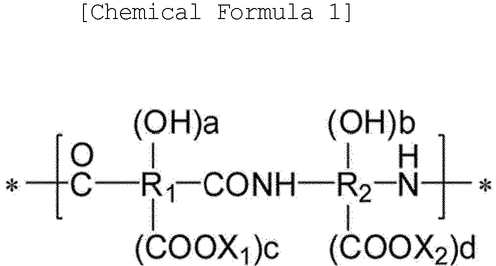

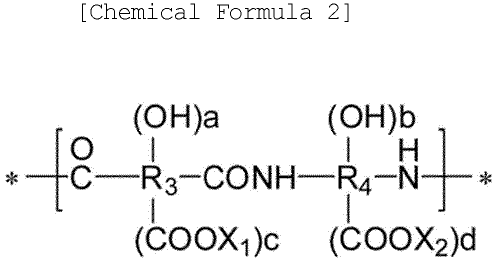

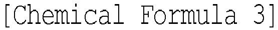

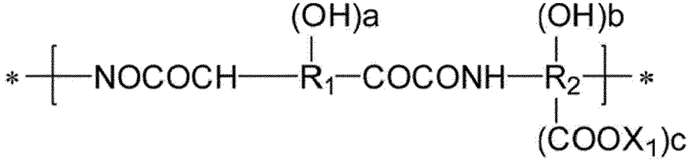

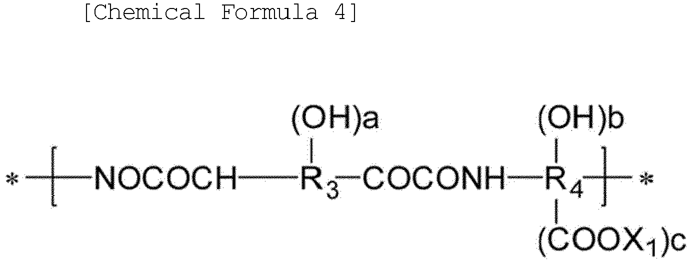

In the Chemical Formulae 1 to 4, R₁, R₂, R₃, and R₄ are each independently an organic group having 5 to 60 carbon atoms, and hydrogen in the organic group may be substituted with a hydroxyl group (OH), methylene group, or fluorine, and methylene group may be substituted with oxygen or nitrogen. When the methylene group is substituted with nitrogen, the remaining electron of nitrogen may be covalently bonded to hydrogen.

In the Chemical Formulae 2 and 4, at least one of R₃ and R₄ may include a structure represented by General Formula 1 below, and specifically, both R₃ and R₄ may include a structure represented by General Formula 1 below. In addition, 5 to 70 mol% of 100 mol% of R₁ to R₄ includes a structure represented by the following General Formula 1. When R₃ to R₄ include a structure represented by General Formula 1, the photosensitive resin composition has excellent folding characteristics, thereby being effective in improving flexibility.

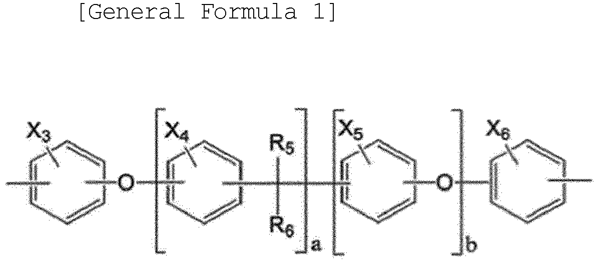

At this time, in the General Formula 1, a and b are each independently an integer in a range of 0 to 10, more specifically 0 to 3, the X3 to X6 are each independently hydrogen or a monovalent organic group having 1 to 5 carbon atoms, and the R5 and R6 are each independently a monovalent organic group having 1 to 10 carbon atoms.

In the Chemical Formula 1 and Chemical Formula 3, X₁ and X₂ are each independently hydrogen or an alkyl group having 1 to 10 carbon atoms.

In the Chemical Formulae 1 to 4, a and b are each independently an integer in a range of 0 to 4, c and d are each independently an integer in a range of 0 to 2, a + b is 1 or more, and when a, b, c, or d is 0, the corresponding substituent is H.

In the Chemical Formulae 2 and 4, R₄ is each independently a structure derived from any one of the structures represented by Chemical Formulae 5 to 14 below, and R₃ is each independently a structure derived from any one of the structures represented by Chemical Formulae 15 to 21 below but is not limited to the following Chemical Formulae.

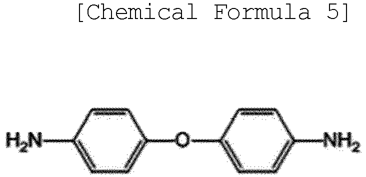

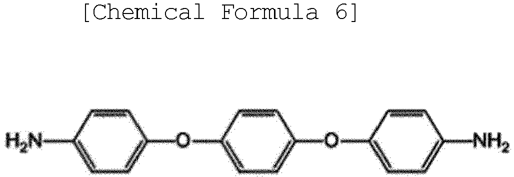

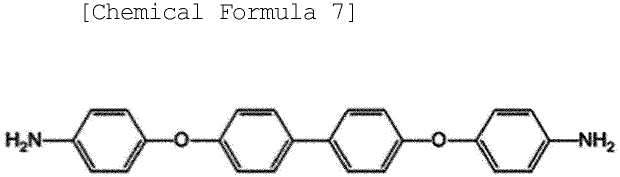

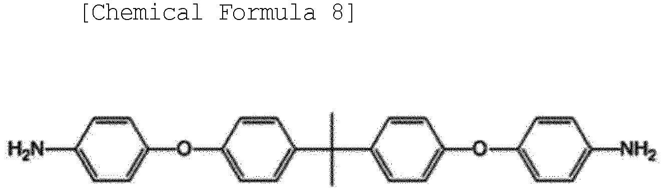

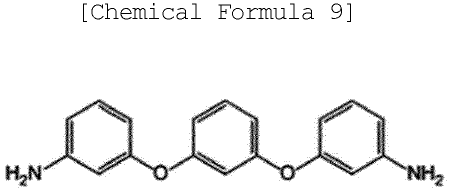

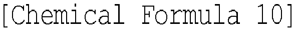

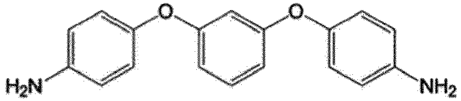

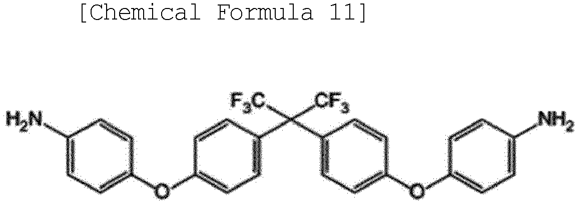

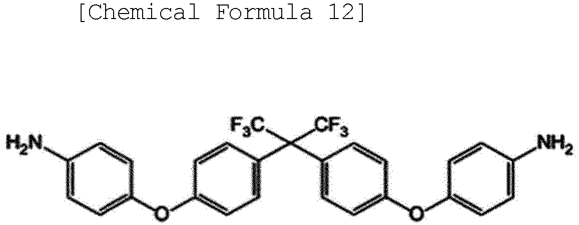

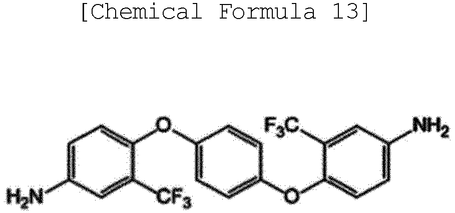

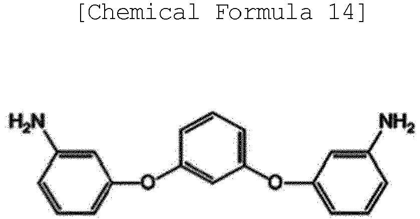

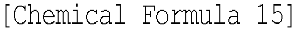

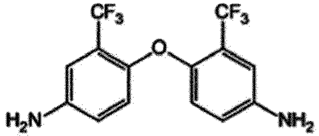

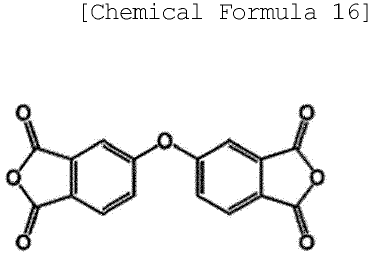

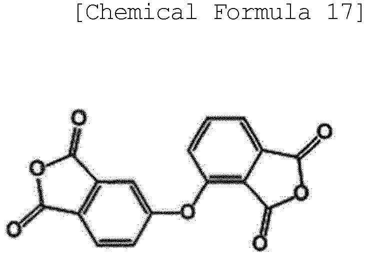

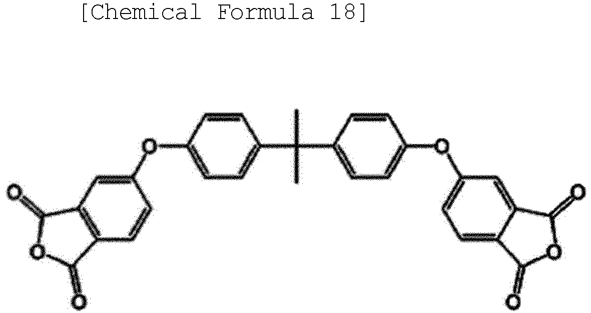

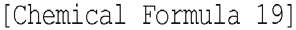

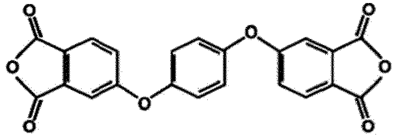

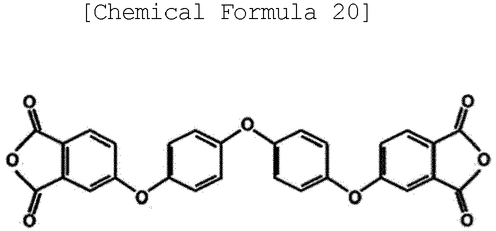

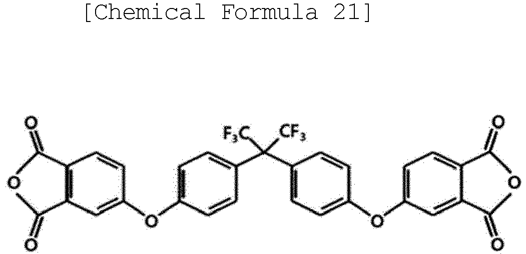

The weight-average molecular weight of the alkali-soluble polymer resin including the repeating units represented by Chemical Formulae 1 to 4 is preferably 2,000 to 20,000 specifically for sensitivity characteristics.

The quinone diazide compound may be obtained by reacting a naphthoquinone diazide sulfonic acid halogen compound with a phenolic compound selected from the group consisting of compounds represented by Chemical Formulae a to h below but is not limited thereto.

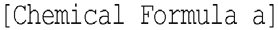

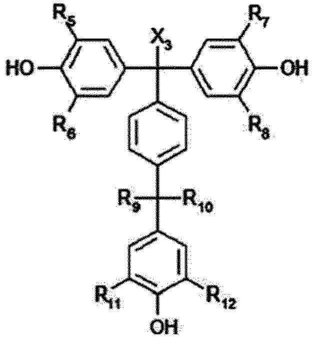

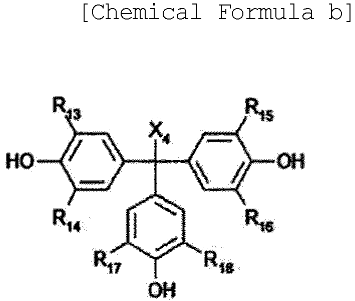

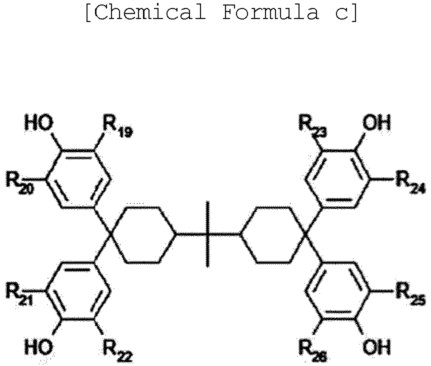

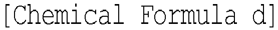

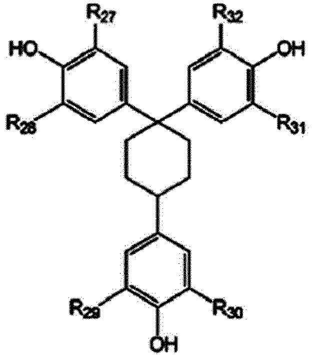

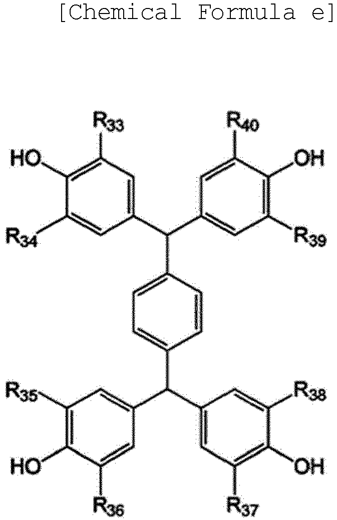

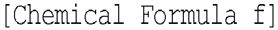

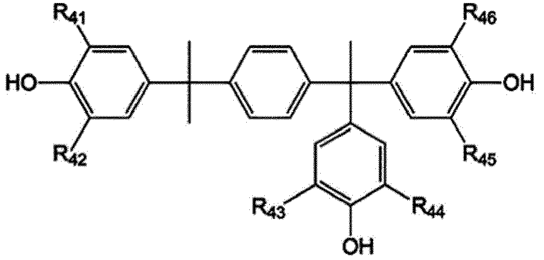

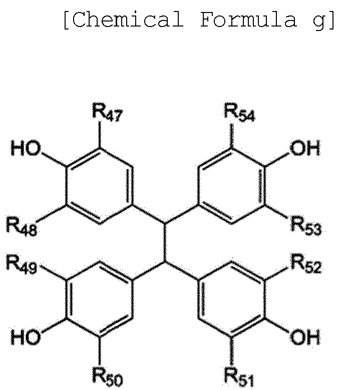

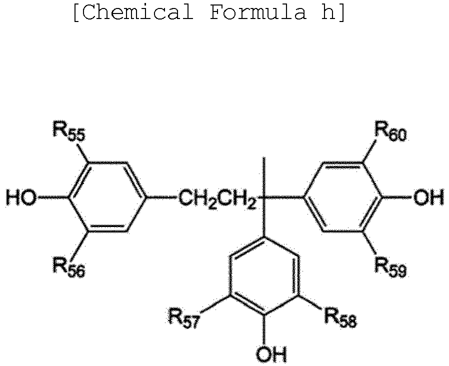

In the Chemical Formulae a to h, R₅ to R₈ and R₁₁ to R₆₀ are each independently hydrogen, halogen, a hydroxyl group, an alkyl group having 1 to 4 carbon atoms, or an alkenyl group having 2 to 4 carbon atoms, X₃ and X₄ are each independently hydrogen, halogen, or an alkyl group having 1 to 4 carbon atoms, and R₉ and R₁₀ are each independently hydrogen or an alkyl group having 1 to 4 carbon atoms. More specifically, each of Chemical Formulae a to h may include at least one alkyl group having 1 to 4 carbon atoms as R₅ to R₈ and R₁₁ to R₆₀, thereby improving sensitivity.

The solvent may be one selected from the group consisting of gamma butyrolactone (GBL), N-methyl pyrrolidone (NMP), propyleneglycol methyl ether acetate (PGMEA), ethyl lactate (EL), methyl-3-methoxypropionate (MMP), propyleneglycol monomethyl ether (PGME), diethylglycol ethylmethyl ether (MEDG), diethylglycol butylmethyl ether (MBDG), diethyleneglycol dimethyl ester (DMDG), diethyleneglycol diethyl ester (DEDG), and a mixture thereof.

The positive photosensitive resin composition of the present disclosure may further include an additive selected from the group consisting of a thermal cross-linking agent, a thermal acid generator, a UV absorber, and a mixture thereof.

The binder may include a compound represented by Chemical Formula 22.

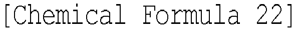

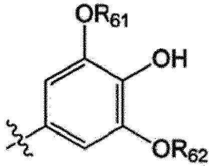

In the Chemical Formula 22, R61 and R62 are each independently a monovalent organic group having 1 to 5 carbon atoms.

The thermal cross-linking agent may be any one of the compounds represented by Chemical Formulae i to n, but is not limited thereto.

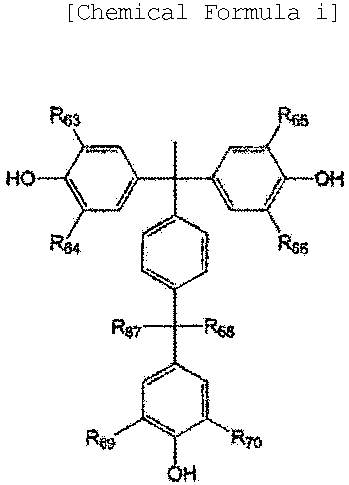

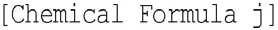

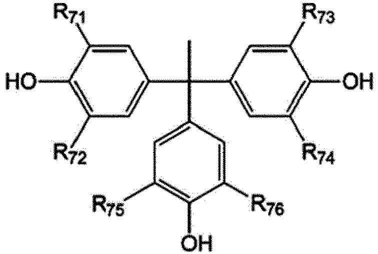

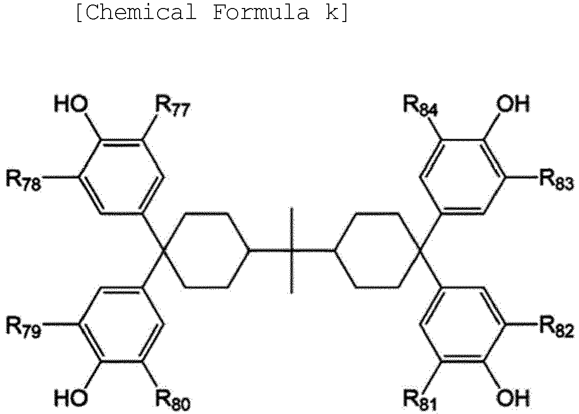

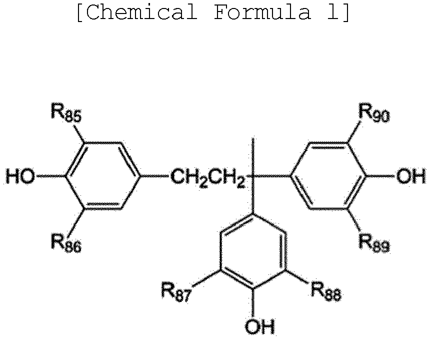

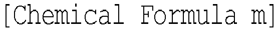

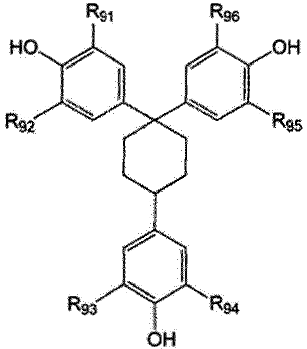

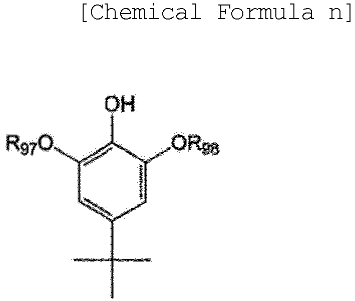

R₆₃ to R₉₈ in the Chemical Formulae i to n are each independently a monovalent organic group having 1 to 5 carbon atoms.

In the positive photosensitive resin composition, the composition, including the thermal cross-linking agent in an amount of 5 to 50 parts by weight based on 100 parts by weight of the alkali-soluble polymer resin, may have excellent adhesive force and chemical resistance.

A cured body, according to an embodiment of the present disclosure, is obtained by curing the photosensitive resin composition. The cured body according to the present disclosure may be folded with a radius of curvature of 1R size or less at a thickness of 3 µm, or in the cured body, cracks do not occur even when 200,000 times of in-folding with a radius of curvature of 1R size at a thickness of 3 um is performed.

A display device, according to an embodiment of the present disclosure, includes a cured body obtained by curing the photosensitive resin composition as an insulating layer. Referring to FIG. 1, among display structures, a cured body of the photosensitive resin composition according to the present disclosure may be applied as at least one insulating layer among interlayer insulating layers 1 and 2.

The display device may be a flexible display device capable of being bent by applying flexibility to an insulating layer.

A semiconductor packaging device, according to an embodiment of the present disclosure, includes a cured body obtained by curing the photosensitive resin composition as an insulating layer. The semiconductor packaging device of the present disclosure includes the cured body capable of exhibiting flexible characteristics as an insulating layer so that problems such as cracks do not occur even under stress caused by a laminated structure.

Hereinafter, embodiments of the present disclosure will be described in detail so that those skilled in the art can easily implement the present disclosure. However, the present disclosure may be embodied in many different forms and is not limited to the embodiments described herein.

### [Production Example: Polyimide resin synthesis]

After putting all the amine series into gamma-butyrolactone (GBL) and dissolving at 60°C, the dianhydride series was added and stirred at 70°C for 4 hours.

Phthalic anhydride (PA) was added and reacted at 70°C for 2 hours, then the temperature was raised to 90°C and heptane was added. The water generated by the imidization reaction at 110°C was removed with a Dean-Stark extractor together with heptane, and after stirring at 150°C for 2 hours, dimethylformamide dimethyl acetal (DFA, 28.4 g, 0.24 mol) was added and stirred at 50°C for 4 hours, then the reaction was terminated, and a polyimide-based resin was synthesized.

In the same manner as above, 87 Production Examples are shown in the table below.

Tables 11 to 19 below are tables showing the contents of GBL, Bis-APAF, TFDB, ODA, TPER, TPEQ, BAPP, BAPB, APB, and 6FODA included in Preparation Examples 1 to 87. A blank in the table below means that the corresponding composition was not included.

**[Table 11]**

| No. | GBL(g ) | Bis-APAF( mol) | TFDB (mol) | ODA (mol) | TPER (mol) | TPEQ (mol) | BAPP (mol) | BAPB (mol) | APB (mol) | 6FODA (mol) | SIDA (mol ) |
|---|---|---|---|---|---|---|---|---|---|---|---|
| 1 | 562.6 | 0.404 | | | 0.022 | | | | | | 0.14 |
| 2 | 562.6 | 0.404 | | | | 0.022 | | | | | 0.14 |
| 3 | 562.6 | 0.404 | | | | | | | | 0.022 | 0.14 |
| 4 | 155 | 0.080 | | | 0.110 | | | | | | 0.00 4 |
| 5 | 562.6 | 0.404 | | | 0.022 | | | | | | 0.14 |
| 6 | 562.6 | 0.404 | | | | 0.022 | | | | | 0.14 |
| 7 | 562.6 | 0.404 | | | | | | | 0.022 | | 0.14 |
| 8 | 562.6 | 0.404 | | | | | | | | 0.022 | 0.14 |
| 9 | 562.6 | 0.404 | | | | | 0.022 | | | | 0.14 |

**[Table 12]**

| No. | GBL(g ) | Bis-APAF (mol ) | TFDB (mol ) | ODA (mol ) | TPER (mol) | TPEQ (mol) | BAPP (mol) | BAPB (mol) | APB (mol) | 6FOD A (mol ) | SIDA (mol ) |
|---|---|---|---|---|---|---|---|---|---|---|---|
| 10 | 562.6 | 0.40 4 | | | | | | 0.022 | | | 0.14 |
| 11 | 562.6 | 0.40 4 | | | 0.022 | | | | | | 0.14 |
| 12 | 562.6 | 0.40 4 | | | | 0.022 | | | | | 0.14 |
| 13 | 562.6 | 0.40 4 | | | | | | | 0.022 | | 0.14 |
| 14 | 562.6 | 0.40 4 | | | | | | | | 0.02 2 | 0.14 |
| 15 | 562.6 | 0.40 4 | | | | | 0.022 | | | | 0.14 |
| 16 | 562.6 | 0.40 4 | | | | | | 0.022 | | | 0.14 |
| 17 | 155 | 0.17 0 | 0.01 0 | 0.01 0 | | | | | | | 0.00 4 |
| 18 | 155 | 0.17 0 | 0.00 5 | | 0.015 | | | | | | 0.00 4 |
| 19 | 155 | 0.17 0 | 0.00 5 | | | 0.015 | | | | | 0.00 4 |

**[Table 13]**

| No. | GBL (9) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 20 | 155 | 0.170 | 0.005 | | | | 0.015 | | | | 0.004 |
| 21 | 155 | 0.170 | 0.005 | | | | | 0.015 | | | 0.004 |
| 22 | 155 | 0.170 | 0.005 | | | | | | 0.015 | | 0.004 |
| 23 | 155 | 0.090 | | 0.100 | | | | | | | 0.004 |
| 24 | 155 | 0.080 | | | 0.110 | | | | | | 0.004 |
| 25 | 155 | 0.075 | | | | 0.115 | | | | | 0.004 |
| 26 | 155 | 0.170 | 0.019 | | | | | | | | 0.004 |
| 27 | 155 | 0.170 | 0.019 | | | | | | | | 0.004 |
| 28 | 155 | 0.170 | 0.019 | | | | | | | | 0.004 |
| 29 | 155 | 0.170 | 0.019 | | | | | | | | 0.004 |

**[Table 14]**

| No. | GBL (g) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 30 | 155 | 0.170 | 0.019 | | | | | | | | 0.004 |
| 31 | 155 | 0.170 | 0.019 | | | | | | | | 0.004 |
| 32 | 155 | 0.170 | 0.019 | | | | | | | | 0.004 |
| 33 | 155 | 0.170 | 0.019 | | | | | | | | 0.004 |
| 34 | 155 | 0.170 | 0.019 | | | | | | | | 0.004 |
| 35 | 155 | 0.170 | | 0.019 | | | | | | | 0.004 |
| 36 | 809 | 0.880 | | | 0.100 | | | | | | 0.020 |
| 37 | 155 | 0.170 | | 0.019 | | | | | | | 0.004 |
| 38 | 809 | 0.880 | | | 0.100 | | | | | | 0.020 |
| 39 | 155 | 0.120 | | | | 0.069 | | | | | 0.004 |

**[Table 15]**

| No. | GBL (g) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 40 | 809 | 0.159 | | | | | 0.030 | | | | 0.020 |
| 41 | 155 | 0.170 | | | | | | 0.019 | | | 0.004 |
| 42 | 155 | 0.170 | | | | | | | 0.019 | | 0.004 |
| 43 | 155 | 0.170 | | | | | | | | 0.019 | 0.004 |
| 44 | 809 | 0.880 | | | | 0.100 | | | | | 0.020 |
| 45 | 809 | 0.880 | | | | | 0.100 | | | | 0.020 |
| 46 | 809 | 0.880 | | | | | | 0.100 | | | 0.020 |
| 47 | 155 | 0.170 | | 0.019 | | | | | | | 0.004 |
| 48 | 155 | 0.170 | | 0.019 | | | | | | | 0.004 |
| 49 | 155 | 0.170 | | 0.019 | | | | | | | 0.004 |

**[Table 16]**

| No. | GBL (g) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 50 | 155 | 0.170 | | 0.019 | | | | | | | 0.004 |
| 51 | 155 | 0.170 | | 0.019 | | | | | | | 0.004 |
| 52 | 809 | 0.880 | | | 0.100 | | | | | | 0.020 |
| 53 | 809 | 0.880 | | | 0.100 | | | | | | 0.020 |
| 54 | 809 | 0.880 | | | 0.100 | | | | | | 0.020 |
| 55 | 809 | 0.880 | | | 0.100 | | | | | | 0.020 |
| 56 | 809 | 0.880 | | | 0.100 | | | | | | 0.020 |
| 57 | 155 | 0.130 | | 0.059 | | | | | | | 0.004 |
| 58 | 155 | 0.090 | | | 0.099 | | | | | | 0.004 |
| 59 | 155 | 0.085 | | | | 0.104 | | | | | 0.004 |

**[Table 17]**

| No. | GBL (g) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 60 | 155 | 0.080 | | | | | | | 0.059 | | 0.004 |
| 61 | 809 | 0.650 | | | 0.330 | | | | | | 0.020 |
| 62 | 809 | 0.580 | | | | 0.400 | | | | | 0.020 |
| 63 | 809 | 0.500 | | | | | 0.480 | | | | 0.020 |
| 64 | 809 | 0.650 | | | 0.330 | | | | | | 0.020 |
| 65 | 809 | 0.580 | | | | 0.400 | | | | | 0.020 |
| 66 | 809 | 0.500 | | | | | 0.480 | | | | 0.020 |
| 67 | 155 | 0.170 | | 0.010 | 0.010 | | | | | | 0.004 |
| 68 | 155 | 0.170 | | 0.010 | | 0.010 | | | | | 0.004 |
| 69 | 155 | 0.170 | | 0.010 | | | 0.010 | | | | 0.004 |

**[Table 18]**

| No. | GBL (g) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 70 | 155 | 0.170 | | 0.010 | | | | 0.010 | | | 0.004 |
| 71 | 155 | 0.170 | | 0.010 | | | | | 0.010 | | 0.004 |
| 72 | 155 | 0.170 | | | | | | | 0.010 | 0.010 | 0.004 |
| 73 | 809 | 0.880 | | 0.050 | | 0.050 | | | | | 0.020 |
| 74 | 809 | 0.880 | | | | 0.033 | 0.033 | | 0.033 | | 0.020 |
| 75 | 809 | 0.880 | | 0.033 | 0.033 | | | | 0.033 | | 0.020 |
| 76 | 155 | 0.170 | | 0.010 | 0.010 | | | | | | 0.004 |
| 77 | 155 | 0.170 | | | 0.010 | 0.010 | | | | | 0.004 |
| 78 | 155 | 0.170 | | | | 0.010 | 0.010 | | | | 0.004 |
| 79 | 155 | 0.170 | | | | | 0.010 | 0.010 | | | 0.004 |

**[Table 19]**

| No. | GBL (g) | Bis-APAF( mol) | TFDB (mol) | ODA (mol) | TPER (mol) | TPEQ (mol) | BAPP (mol) | BAPB (mol) | APB (mol) | 6FOD A (mol) | SIDA (mol) |
|---|---|---|---|---|---|---|---|---|---|---|---|
| 80 | 155 | 0.170 | | | | | | 0.010 | 0.010 | | 0.004 |
| 81 | 155 | 0.170 | | | | | | | 0.010 | 0.010 | 0.004 |
| 82 | 809 | 0.880 | | | 0.050 | 0.050 | | | | | 0.020 |
| 83 | 809 | 0.880 | | | | 0.033 | 0.033 | | 0.033 | | 0.020 |
| 84 | 809 | 0.880 | | 0.033 | 0.033 | | | | 0.033 | | 0.020 |
| 85 | 809 | 0.880 | | 0.033 | 0.033 | | | | 0.033 | | 0.020 |
| 86 | 155 | 0.170 | | Chemic al Formul a 23¹⁾ 0.019 | | | | | | | 0.004 |
| 87 | 155 | 0.170 | 0.019 | | | | | | | | |

- ODA: 1,3-bis(4-aminophenoxy)benzene
- TPER: 1,3-bis(4-aminophenoxy)benzene
- TPEQ: 1,4-bis(4-aminophenoxy)benzene
- BAPP: 2,2'-bis(4-aminophenoxyphenyl)propane
- BAPB: 4,4-bis(4-aminophenoxy)biphenyl
- APB: 1,3-bis(3-aminophenoxy)benzene
- 6FODA: 2,2'-bis(trifluoromethyl)-4,4'-diaminophenylether
- SIDA: 3,3'-(1,1,3,3-tetramethyldisiloxane-1,3-diyl)bis(propan-1-amine)

### 1) In Production Example 86, diamine of Chemical Formula 23 is used instead of ODA

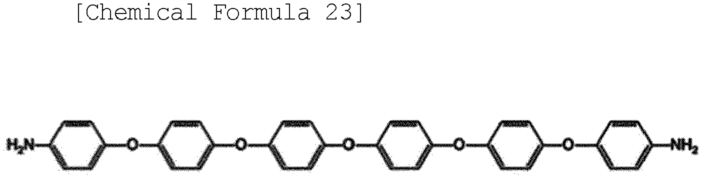

In addition, Tables 21 to 29 below are tables showing the contents of SIDA, ODPA, P6FDA, BPDA, Chemical Formula 17, Chemical Formula 18, Chemical Formula 19, Chemical Formula 20, and Chemical Formula 21 included in Production Examples 1 to 87. A blank in the table below means that the corresponding composition was not included.

**[Table 21]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 1 | | 0.296 | | | | | | |
| 2 | | 0.296 | | | | | | |
| 3 | 0.015 | 0.281 | | | | | | |
| 4 | 0.131 | | | | | | | |
| 5 | | 0.296 | | | | | | |
| 6 | | 0.296 | | | | | | |
| 7 | | 0.296 | | | | | | |
| 8 | 0.015 | 0.281 | | | | | | |
| 9 | 0.015 | 0.281 | | | | | | |

| | | | | | | | | |
|---|---|---|---|---|---|---|---|---|
| (Unit: mol) | | | | | | | | |

**[Table 22]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 10 | 0.015 | 0.281 | | | | | | |
| 11 | 0.015 | | 0.281 | | | | | |
| 12 | 0.015 | | 0.281 | | | | | |
| 13 | 0.015 | | 0.281 | | | | | |
| 14 | | | 0.296 | | | | | |
| 15 | | | 0.296 | | | | | |
| 16 | | | 0.296 | | | | | |
| 17 | | 0.131 | | | | | | |
| 18 | | 0.131 | | | | | | |
| 19 | | 0.131 | | | | | | |

| | | | | | | | | |
|---|---|---|---|---|---|---|---|---|
| (Unit: mol) | | | | | | | | |

**[Table 23]**

| No. | ODPA | P6FDA | BPDA | Chemical Formula | Chemical Formula | Chemical Formula | Chemical Formula | Chemical Formula |
|---|---|---|---|---|---|---|---|---|
| | | | | 17 | 18 | 19 | 20 | 21 |
| 20 | | 0.131 | | | | | | |
| 21 | | 0.131 | | | | | | |
| 22 | | 0.131 | | | | | | |
| 23 | 0.131 | | | | | | | |
| 24 | 0.131 | | | | | | | |
| 25 | 0.131 | | | | | | | |
| 26 | 0.066 | 0.066 | | | | | | |
| 27 | 0.099 | | 0.033 | | | | | |
| 28 | 0.066 | 0.033 | 0.033 | | | | | |
| 29 | 0.085 | 0.047 | | | | | | |

| | | | | | | | | |
|---|---|---|---|---|---|---|---|---|
| (Unit: mol) | | | | | | | | |

**[Table 24]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 30 | 0.085 | 0.020 | 0.027 | | | | | |
| 31 | | | | 0.066 | | | | |
| 32 | 0.066 | 0.066 | | | | | | |
| 33 | 0.099 | | 0.033 | | | | | |
| 34 | 0.066 | 0.033 | 0.033 | | | | | |
| 35 | 0.120 | 0.019 | | | | | | |
| 36 | 0.660 | | 0.020 | | | | | |
| 37 | 0.139 | | | | | | | |
| 38 | 0.680 | | | | | | | |
| 39 | 0.139 | | | | | | | |

| | | | | | | | | |
|---|---|---|---|---|---|---|---|---|
| (Unit: mol) | | | | | | | | |

**[Table 25]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 40 | 0.430 | 0.250 | | | | | | |
| 41 | 0.139 | | | | | | | |
| 42 | 0.139 | | | | | | | |
| 43 | 0.139 | | | | | | | |
| 44 | 0.680 | | | | | | | |
| 45 | 0.680 | | | | | | | |
| 46 | 0.680 | | | | | | | |
| 47 | | | | 0.131 | | | | |
| 48 | | | | | 0.131 | | | |
| 49 | | | | | | 0.131 | | |

| | | | | | | | | |
|---|---|---|---|---|---|---|---|---|
| (Unit: mol) | | | | | | | | |

**[Table 26]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 50 | | | | | | | 0.131 | |
| 51 | | | | | | | | 0.131 |
| 52 | 0.340 | | | 0.340 | | | | |
| 53 | | | | | 0.680 | | | |
| 54 | | | | | | 0.680 | | |
| 55 | | | | | | | 0.680 | |
| 56 | | | | | | | | 0.680 |
| 57 | 0.120 | 0.019 | | | | | | |
| 58 | 0.120 | 0.019 | | | | | | |
| 59 | 0.120 | 0.019 | | | | | | |

| | | | | | | | | |
|---|---|---|---|---|---|---|---|---|
| (Unit: mol) | | | | | | | | |

**[Table 27]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 60 | 0.120 | 0.019 | | | | | | |
| 61 | 0.660 | | 0.020 | | | | | |
| 62 | 0.660 | | 0.020 | | | | | |
| 63 | 0.660 | | 0.020 | | | | | |
| 64 | | | 0.020 | 0.660 | | | | |
| 65 | | | 0.020 | | 0.660 | | | |
| 66 | | | 0.020 | | | 0.660 | | |
| 67 | 0.131 | | | | | | | |
| 68 | 0.131 | | | | | | | |
| 69 | 0.131 | | | | | | | |

| | | | | | | | | |
|---|---|---|---|---|---|---|---|---|
| (Unit: mol) | | | | | | | | |

**[Table 28]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 70 | 0.131 | | | | | | | |
| 71 | 0.131 | | | | | | | |
| 72 | 0.131 | | | | | | | |
| 73 | 0.680 | | | | | | | |
| 74 | | | | | 0.680 | | | |
| 75 | 0.680 | | | | | | | |
| 76 | | | | 0.131 | | | | |
| 77 | | | | | 0.131 | | | |
| 78 | | | | | | 0.131 | | |
| 79 | | | | | | | 0.131 | |

| | | | | | | | | |
|---|---|---|---|---|---|---|---|---|
| (Unit: mol) | | | | | | | | |

**[Table 29]**

| No. | ODPA | P6FDA | BPDA | Chemical Formula 17 | Chemical Formula 18 | Chemical Formula 19 | Chemical Formula 20 | Chemical Formula 21 |
|---|---|---|---|---|---|---|---|---|
| 80 | | | | | | | | 0.131 |
| 81 | 0.066 | | | 0.066 | | | | |
| 82 | | | | | 0.680 | | | |
| 83 | | | | | | 0.680 | | |
| 84 | | | | | | | 0.680 | |
| 85 | | | | | | | | 0.680 |
| 86 | 0.120 | 0.019 | | | | | | |
| 87 | 0.131 | | | | | | | |

| | | | | | | | | |
|---|---|---|---|---|---|---|---|---|
| (Unit: mol) | | | | | | | | |

- ODPA: 4,4'-oxydiphthalic anhydride
- P6FDA: 1,4-bis(trifluoromethyl)-2,3,5,6-benzenetetracarboxylic dianhydride
- BPDA: 3,3',4,4'-biphenyltetracarboxylic dianhydride

Tables 31 to 39 below are sequentially shown with respect to phthalic anhydride (PA) (mol), DMF-methylacetal (DFA) (mol), imidization temperature (°C), and time contained in Production Examples 1 to 87.

**[Table 31]**

| No. | PA (mol) | DFA (mol) | Imidization temperature (°C) and time (h) |
|---|---|---|---|
| 1 | 0.278 | 0.24 | 50, 4 |
| 2 | 0.278 | 0.24 | 50, 4 |
| 3 | 0.278 | 0.24 | 50, 4 |
| 4 | 0.124 | - | 50, 4 |
| 5 | 0.278 | 0.24 | 150, 2 |
| 6 | 0.278 | 0.24 | 150, 2 |
| 7 | 0.278 | 0.24 | 150, 2 |
| 8 | 0.278 | 0.24 | 150, 2 |
| 9 | 0.278 | 0.24 | 150, 2 |

**[Table 32]**

| No. | PA (mol) | DFA (mol) | Imidization temperature (°C) and time (h) |
|---|---|---|---|
| 10 | 0.278 | 0.24 | 150, 2 |
| 11 | 0.278 | 0.24 | 150, 2 |
| 12 | 0.278 | 0.24 | 150, 2 |
| 13 | 0.278 | 0.24 | 150, 2 |
| 14 | 0.278 | 0.24 | 150, 2 |
| 15 | 0.278 | 0.24 | 150, 2 |
| 16 | 0.278 | 0.24 | 150, 2 |
| 17 | 0.124 | - | 180, 4 |
| 18 | 0.124 | - | 180, 4 |
| 19 | 0.124 | - | 180, 4 |

**[Table 33]**

| No. | PA (mol) | DFA (mol) | Imidization temperature (°C) and time (h) |
|---|---|---|---|
| 20 | 0.124 | - | 180, 4 |
| 21 | 0.124 | - | 180, 4 |
| 22 | 0.124 | - | 180, 4 |
| 23 | 0.124 | - | 180, 4 |
| 24 | 0.124 | - | 180, 4 |
| 25 | 0.124 | - | 180, 4 |
| 26 | 0.124 | - | 150, 2 |
| 27 | 0.124 | - | 150, 2 |
| 28 | 0.124 | - | 150, 2 |
| 29 | 0.124 | - | 150, 2 |

**[Table 34]**

| No. | PA (mol) | DFA (mol) | Imidization temperature (°C) and time (h) |
|---|---|---|---|
| 30 | 0.124 | - | 150, 2 |
| 31 | 0.124 | - | 150, 2 |
| 32 | 0.124 | - | 180, 4 |
| 33 | 0.124 | - | 180, 4 |
| 34 | 0.124 | - | 180, 4 |
| 35 | 0.124 | - | 180, 4 |
| 36 | 0.640 | 0.34 | 180, 4 |
| 37 | 0.124 | - | 180, 4 |
| 38 | 0.640 | 0.34 | 150, 4 |
| 39 | 0.124 | - | 180, 4 |

**[Table 35]**

| No. | PA (mol) | DFA (mol) | Imidization temperature (°C) and time (h) |
|---|---|---|---|
| 40 | 0.640 | 0.34 | 150, 4 |
| 41 | 0.124 | - | 180, 4 |
| 42 | 0.124 | - | 180, 4 |
| 43 | 0.124 | - | 180, 4 |
| 44 | 0.640 | 0.34 | 150, 4 |
| 45 | 0.640 | 0.34 | 150, 4 |
| 46 | 0.640 | 0.34 | 150, 4 |
| 47 | 0.124 | - | 180, 4 |
| 48 | 0.124 | - | 180, 4 |
| 49 | 0.124 | - | 180, 4 |

**[Table 36]**

| No. | PA (mol) | DFA (mol) | Imidization temperature (°C) and time (h) |
|---|---|---|---|
| 50 | 0.124 | - | 180, 4 |
| 51 | 0.124 | - | 180, 4 |
| 52 | 0.640 | 0.34 | 150, 4 |
| 53 | 0.640 | 0.34 | 150, 4 |
| 54 | 0.640 | 0.34 | 150, 4 |
| 55 | 0.640 | 0.34 | 150, 4 |
| 56 | 0.640 | 0.34 | 150, 4 |
| 57 | 0.124 | - | 180, 4 |
| 58 | 0.124 | - | 180, 4 |
| 59 | 0.124 | - | 180, 4 |

**[Table 37]**

| No. | PA (mol) | DFA (mol) | Imidization temperature (°C) and time (h) |
|---|---|---|---|
| 60 | 0.124 | - | 180, 4 |
| 61 | 0.640 | 0.34 | 150, 4 |
| 62 | 0.640 | 0.34 | 150, 4 |
| 63 | 0.640 | 0.34 | 150, 4 |
| 64 | 0.640 | 0.34 | 150, 4 |
| 65 | 0.640 | 0.34 | 150, 4 |
| 66 | 0.640 | 0.34 | 150, 4 |
| 67 | 0.124 | - | 180, 4 |
| 68 | 0.124 | - | 180, 4 |
| 69 | 0.124 | - | 180, 4 |

**[Table 38]**

| No. | PA (mol) | DFA (mol) | Imidization temperature (°C) and time (h) |
|---|---|---|---|
| 70 | 0.124 | - | 180, 4 |
| 71 | 0.124 | - | 180, 4 |
| 72 | 0.124 | - | 180, 4 |
| 73 | 0.640 | 0.34 | 150, 4 |
| 74 | 0.640 | 0.34 | 150, 4 |
| 75 | 0.640 | 0.34 | 150, 4 |
| 76 | 0.124 | - | 150, 4 |
| 77 | 0.124 | - | 180, 4 |
| 78 | 0.124 | - | 180.4 |
| 79 | 0.124 | - | 180.4 |

**[Table 39]**

| No. | PA (mol) | DFA (mol) | Imidization temperature (°C) and time (h) |
|---|---|---|---|
| 80 | 0.124 | - | 180, 4 |
| 81 | 0.124 | - | 180, 4 |
| 82 | 0.640 | 0.34 | 150, 4 |
| 83 | 0.640 | 0.34 | 150, 4 |
| 84 | 0.640 | 0.34 | 150, 4 |
| 85 | 0.640 | 0.34 | 150, 4 |
| 86 | 0.124 | - | 180, 4 |
| 87 | 0.124 | - | 180, 4 |

Tables 41 to 49 below are tables showing the contents of hinges and ODPA (4,4'-oxydiphthalic anhydride) excluding PA included in Production Examples 1 to 85.

**[Table 41]**

| No. | Hinge content (mol%), excluding PA | ODPA content |
|---|---|---|
| 1 | 2.5% | 0.0% |
| 2 | 2.5% | 0.0% |
| 3 | 4.3% | 1.7% |
| 4 | 74.2% | 40.3% |
| 5 | 2.5% | 0.0% |
| 6 | 2.5% | 0.0% |
| 7 | 2.5% | 0.0% |
| 8 | 4.3% | 1.7% |
| 9 | 4.3% | 1.7% |

**[Table 42]**

| No. | Hinge content (mol%), excluding PA | ODPA content |
|---|---|---|
| 10 | 4.3% | 1.7% |
| 11 | 4.3% | 1.7% |
| 12 | 4.3% | 1.7% |
| 13 | 4.3% | 1.7% |
| 14 | 2.5% | 0.0% |
| 15 | 2.5% | 0.0% |
| 16 | 2.5% | 0.0% |
| 17 | 3.1% | 0.0% |
| 18 | 4.6% | 0.0% |
| 19 | 4.6% | 0.0% |

**[Table 43]**

| No. | Hinge content (mol%), excluding PA | ODPA content |
|---|---|---|
| 20 | 4.6% | 0.0% |
| 21 | 4.6% | 0.0% |
| 22 | 4.6% | 0.0% |
| 23 | 71.1% | 40.3% |
| 24 | 74.2% | 40.3% |
| 25 | 75.7% | 40.3% |
| 26 | 20.3% | 20.3% |
| 27 | 30.5% | 30.5% |
| 28 | 20.3% | 20.3% |
| 29 | 26.2% | 26.2% |

**[Table 44]**

| No. | Hinge content (mol%), excluding PA | ODPA content |
|---|---|---|
| 30 | 26.2% | 26.2% |
| 31 | 25.5% | 0.0% |
| 32 | 20.3% | 20.3% |
| 33 | 30.5% | 30.5% |
| 34 | 20.3% | 20.3% |
| 35 | 42.0% | 36.1% |
| 36 | 45.2% | 39.3% |
| 37 | 47.7% | 41.9% |
| 38 | 46.4% | 40.5% |
| 39 | 62.7% | 41.9% |

**[Table 45]**

| No. | Hinge content (mol%), excluding PA | ODPA content |
|---|---|---|
| 40 | 51.7% | 48.4% |
| 41 | 47.6% | 41.9% |
| 42 | 47.6% | 41.9% |
| 43 | 47.6% | 41.9% |
| 44 | 46.4% | 40.5% |
| 45 | 46.4% | 40.5% |
| 46 | 46.4% | 40.5% |
| 47 | 46.4% | 0.0% |
| 48 | 46.4% | 0.0% |
| 49 | 46.4% | 0.0% |

**[Table 46]**

| No. | Hinge content (mol%), excluding PA | ODPA content |
|---|---|---|
| 50 | 46.4% | 0.0% |
| 51 | 46.4% | 0.0% |
| 52 | 46.4% | 20.2% |
| 53 | 46.4% | 0.0% |
| 54 | 46.4% | 0.0% |
| 55 | 46.4% | 0.0% |
| 56 | 46.4% | 0.0% |
| 57 | 53.9% | 36.2% |
| 58 | 66.0% | 36.2% |
| 59 | 67.5% | 36.2% |

**[Table 47]**

| No. | Hinge content (mol%), excluding PA | ODPA content |
|---|---|---|
| 60 | 63.5% | 42.6% |
| 61 | 58.9% | 39.3% |
| 62 | 63.1% | 39.3% |
| 63 | 67.9% | 39.3% |
| 64 | 58.9% | 0.0% |
| 65 | 63.1% | 0.0% |
| 66 | 67.9% | 0.0% |
| 67 | 46.5% | 40.4% |
| 68 | 46.5% | 40.4% |
| 69 | 46.5% | 40.4% |

**[Table 48]**

| No. | Hinge content (mol%), excluding PA | ODPA content |
|---|---|---|
| 70 | 46.5% | 40.4% |
| 71 | 46.5% | 40.4% |
| 72 | 46.5% | 40.4% |
| 73 | 46.4% | 40.5% |
| 74 | 46.4% | 0.0% |
| 75 | 46.4% | 40.5% |
| 76 | 46.5% | 0.0% |
| 77 | 46.5% | 0.0% |
| 78 | 46.5% | 0.0% |
| 79 | 46.5% | 0.0% |

**[Table 49]**

| No. | Hinge content (mol%), excluding PA | ODPA content |
|---|---|---|
| 80 | 46.5% | 0.0% |
| 81 | 46.7% | 20.3% |
| 82 | 46.4% | 0.0% |
| 83 | 46.4% | 0.0% |
| 84 | 46.4% | 0.0% |
| 85 | 46.4% | 0.0% |
| 86 | 42.0% | 36.1% |
| 87 | 40.4% | 40.4% |

### [Example: Preparation of photosensitive resin composition]

A photosensitive resin composition was prepared using 24 parts by weight of a quinone diazide compound (Tris-TPPA) based on 100 parts by weight of the polyimide-based resin synthesized under the same conditions as in Production Examples 1 to 87 of Tables 11 to 49, and 9 and 10 parts by weight of Chemical Formulae d and i, respectively, as a crosslinking agent.

### [Experimental Example: Characterization]

The photosensitive resin composition Examples 1 to 87 prepared according to the above Examples including the polyimide-based resins of Production Examples 1 to 87 prepared according to the conditions described in Tables 11 to 49 are applied on a substrate. Thereafter, a thin film was applied on a Ti/Al/Ti substrate using a slit coater and then dried on a hot plate at 120°C for 2 minutes to form a film with a thickness of 3.0 um. Physical properties of the photoresist, such as imidization rate, sensitivity, scum, crack, chemical resistance, adhesive strength, OLED reliability, and folding characteristics, were measured using the fabricated substrate.

### [ Experimental Example 1: Imidization rate evaluation]

The photosensitive resin composition prepared in the above example is applied on a substrate. Then, after applying a thin film composition on a glass substrate using a slit coater, the applied composition was dried on a hot plate at 120°C for 2 minutes and cured at 250°C and 350°C for 1 hour each to form a film having a thickness of 3.0 µm, and IR was measured for the film. Based on the C=C stretching peak intensity of benzene, which does not change during imidization, the imidization index was confirmed through the C-N-C peak intensity according to the imide reaction (Peak of C-N-C / Peak of C=C @aromatic). Assuming that the imidization rate is 100% at the time of 350°C cure, the imidization rate at the time of 250°C cure is calculated and shown in Tables 51 to 59 below.

### [Experimental Example 2: Sensitivity Measurement]

After applying ultraviolet rays having an intensity of 20 mW/cm ² in a broadband based on the formation of a 5 um contact hole CD formation reference dose on the substrate coated with each photosensitive resin composition using a predetermined pattern mask, the substrate coated with each photosensitive resin composition was developed at 23°C for 1 minute with an aqueous solution of 2.38 parts by weight of tetramethylammonium hydroxide and washed with ultrapure water for 1 minute. Thereafter, the prepared substrate was cured at 250°C for 60 minutes in an oven to obtain a pattern film having a contact hole CD of 7 µm. When 40 to 150 mJ/cm² is satisfied with an appropriate result value, the sensitivity is shown as in Tables 51 to 59 below as ∘.

### [Experimental Example 3: Measurement of Scum]

During the sensitivity measurement, the inside of the pattern was observed with SEM to check whether residues were present in lines, spaces, and contact holes. When the development residue is present, it is marked as X, and when it is not present, as O, in Tables 51 to 59 below.

### [Experimental Example 4: Measurement of Crack]

The prepared substrate was visually inspected and observed under a microscope at 100 times magnification, when cracks were observed, it was marked as X, when cracks were not observed, it was marked as ∘, in Tables 51 to 59 below.

### [Experimental Example 5: Measurement of Chemical Resistance]

The prepared substrate was immersed in a 25°C evaluation solvent for 120 seconds, and the cured film thickness change rate before and after immersion was measured. 0 to less than 150 Å is ⊚, 150 or more to less than 300 Å is ∘, 300 or more to less than 600 Å is △, and 600 Å or more is marked as X in Tables 51 to 59 (evaluation solvent is propylene glycol methyl ether: propylene glycol methyl ether acetate = 7:3 molar ratio).

### [Experimental Example 6: Measurement of adhesive strength]

A pattern film was formed in the same manner as in the case of sensitivity measurement, but the adhesive strength according to the baking temperature was compared based on the case where the line width and a slit width of 10 µm were 1:1. At this time, if the adhesive force is secured at 90°C to 100°C in the prebake, it is marked as ∘, if the adhesive force is secured in the prebake temperature of 105°C to 115°C, it is marked as △, if the adhesive force is secured in the prebake temperature of 120°C or more, it is marked as NG, and results are shown in Tables 51 to 59 below.

### [Experimental Example 7: Measurement of OLED Reliability]

A pixel define layer (PDL) and a VIA pattern film of an OLED device can be formed in the same manner as in the case of sensitivity measurement, and FIG. 1 is a diagram showing that a pixel define layer (PDL) and VIA Pattern layer are formed on an ITO substrate on which a pattern is formed, and EL is deposited. As shown in FIG. 1, Al is deposited as a cathode electrode on the top portion, and the encapsulation process is performed. In measurement conditions of 85°C, 85% RH standard, the time (T97) for 3% luminance drop in the device on state was evaluated. When 1000 hours or more were secured, it is marked as ∘, when 800 hours or more and less than 1000 hours were secured, it is marked as △, and when less than 800 hours were secured, it is marked as NG in Tables 51 to 59 below.

### [Experimental Example 8: Folding characteristic measurement]

When a PI film of 100 µm is applied with the materials of the Comparative Examples and Examples in Table 2 having a thickness of 3 um and in-folding is performed 200,000 times with a radius of curvature of 1R size, if multiple cracks in the folding portion are observed, it is marked as NG, if some cracks in the folding portion are observed, it is marked as △, and if cracks are not observed, it is marked as ∘ in Tables 51 to 59 below.

**[Table 51]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 1 | ○ | ○ | ○ | NG | NG | NG | NG | 5 |
| 2 | ○ | ○ | ○ | NG | NG | NG | NG | 11 |
| 3 | ○ | ○ | ○ | NG | NG | NG | NG | 13 |
| 4 | ○ | ○ | ○ | NG | NG | NG | ○ | 9 |
| 5 | ○ | ○ | ○ | NG | ○ | NG | NG | 25 |
| 6 | ○ | ○ | ○ | NG | ○ | NG | NG | 39 |
| 7 | ○ | ○ | ○ | NG | ○ | NG | NG | 19 |
| 8 | ○ | ○ | ○ | NG | ○ | NG | NG | 21 |
| 9 | ○ | ○ | ○ | NG | ○ | NG | NG | 23 |

**[Table 52]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 10 | ○ | ○ | ○ | NG | ○ | NG | NG | 55 |
| 11 | ○ | ○ | ○ | NG | ○ | NG | NG | 71 |
| 12 | ○ | ○ | ○ | NG | ○ | NG | NG | 57 |
| 13 | ○ | ○ | ○ | NG | ○ | NG | NG | 56 |
| 14 | ○ | ○ | ○ | NG | ○ | NG | NG | 78 |
| 15 | ○ | ○ | ○ | NG | ○ | NG | NG | 81 |
| 16 | ○ | ○ | ○ | NG | ○ | NG | NG | 49 |
| 17 | ○ | ○ | ○ | ○ | ○ | ○ | NG | 50 |
| 18 | ○ | ○ | ○ | ○ | ○ | ○ | NG | 45 |
| 19 | ○ | ○ | ○ | ○ | ○ | ○ | NG | 47 |

**[Table 53]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 20 | ○ | ○ | ○ | ○ | ○ | ○ | NG | 55 |
| 21 | ○ | ○ | ○ | ○ | ○ | ○ | NG | 71 |
| 22 | ○ | ○ | ○ | ○ | ○ | ○ | NG | 57 |
| 23 | ○ | ○ | ○ | ○ | ○ | ○ | ○ | 56 |
| 24 | ○ | ○ | ○ | ○ | ○ | ○ | ○ | 78 |
| 25 | ○ | ○ | ○ | ○ | ○ | ○ | ○ | 81 |
| 26 | ○ | ○ | ○ | Δ | ○ | Δ | ○ | 49 |
| 27 | ○ | ○ | ○ | Δ | ○ | Δ | ○ | 50 |
| 28 | ○ | ○ | ○ | Δ | ○ | Δ | ○ | 45 |
| 29 | ○ | ○ | ○ | Δ | ○ | Δ | ○ | 47 |

**[Table 54]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 30 | ○ | ○ | ○ | Δ | ○ | Δ | ○ | 50 |
| 31 | ○ | ○ | ○ | Δ | ○ | Δ | ○ | 44 |
| 32 | ○ | ○ | ○ | ○ | ○ | ○ | Δ | 73 |
| 33 | ○ | ○ | ○ | ○ | ○ | ○ | Δ | 70 |
| 34 | ○ | ○ | ○ | ○ | ○ | ○ | Δ | 88 |
| 35 | ○ | ○ | ○ | ○ | ○ | ○ | ○ | 85 |
| 36 | ○ | ○ | ○ | ○ | ○ | ○ | ○ | 71 |
| 37 | ○ | ○ | ○ | ○ | ○ | ○ | ○ | 85 |
| 38 | ○ | ○ | ○ | ○ | ○ | ○ | ○ | 51 |
| 39 | ○ | ○ | ○ | ○ | ○ | ○ | ○ | 84 |

**[Table 55]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 40 | ○ | ○ | ○ | ○ | ○ | ○ | ○ | 53 |
| 41 | ○ | ○ | ○ | ○ | ○ | ○ | ○ | 83 |
| 42 | ○ | ○ | ○ | ○ | ○ | ○ | ○ | 79 |
| 43 | ○ | ○ | ○ | ○ | ○ | ○ | ○ | 80 |
| 44 | ○ | ○ | ○ | ○ | ○ | ○ | ○ | 59 |
| 45 | ○ | ○ | ○ | ○ | ○ | ○ | ○ | 61 |
| 46 | ○ | ○ | ○ | ○ | ○ | ○ | ○ | 52 |
| 47 | ○ | ○ | ○ | ○ | ○ | ○ | ○ | 83 |
| 48 | ○ | ○ | ○ | ○ | ○ | ○ | ○ | 90 |
| 49 | ○ | ○ | ○ | ○ | ○ | ○ | ○ | 81 |

**[Table 56]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 50 | ○ | ○ | ○ | ○ | ○ | ○ | ○ | 85 |
| 51 | ○ | ○ | ○ | ○ | ○ | ○ | ○ | 88 |
| 52 | ○ | ○ | ○ | ○ | ○ | ○ | ○ | 71 |
| 53 | ○ | ○ | ○ | ○ | ○ | ○ | ○ | 69 |
| 54 | ○ | ○ | ○ | ○ | ○ | ○ | ○ | 65 |
| 55 | ○ | ○ | ○ | ○ | ○ | ○ | ○ | 73 |
| 56 | ○ | ○ | ○ | ○ | ○ | ○ | ○ | 72 |
| 57 | ○ | ○ | ○ | ○ | ○ | ○ | ○ | 80 |
| 58 | ○ | ○ | ○ | ○ | ○ | ○ | ○ | 81 |
| 59 | ○ | ○ | ○ | ○ | ○ | ○ | ○ | 79 |

**[Table 57]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 60 | ○ | ○ | ○ | ○ | ○ | ○ | ○ | 86 |
| 61 | ○ | ○ | ○ | ○ | ○ | ○ | ○ | 75 |
| 62 | ○ | ○ | ○ | ○ | ○ | ○ | ○ | 72 |
| 63 | ○ | ○ | ○ | ○ | ○ | ○ | ○ | 70 |
| 64 | ○ | ○ | ○ | ○ | ○ | ○ | ○ | 69 |
| 65 | ○ | ○ | ○ | ○ | ○ | ○ | ○ | 68 |
| 66 | ○ | ○ | ○ | ○ | ○ | ○ | ○ | 71 |
| 67 | ○ | ○ | ○ | ○ | ○ | ○ | ○ | 85 |
| 68 | ○ | ○ | ○ | ○ | ○ | ○ | ○ | 91 |
| 69 | ○ | ○ | ○ | ○ | ○ | ○ | ○ | 89 |

**[Table 58]**

| No. | Sensiti vity | Scum | Crack | Chemical resistan ce | Adhesio n force | OLED reliabi lity | Folding charact eristic | Imidiza tion rate (%) |
|---|---|---|---|---|---|---|---|---|
| 70 | ○ | ○ | ○ | ○ | ○ | ○ | ○ | 90 |
| 71 | ○ | ○ | ○ | ○ | ○ | ○ | ○ | 88 |
| 72 | ○ | ○ | ○ | ○ | ○ | ○ | ○ | 89 |
| 73 | ○ | ○ | ○ | ○ | ○ | ○ | ○ | 74 |
| 74 | ○ | ○ | ○ | ○ | ○ | ○ | ○ | 75 |
| 75 | ○ | ○ | ○ | ○ | ○ | ○ | ○ | 71 |
| 76 | ○ | ○ | ○ | ○ | ○ | ○ | ○ | 76 |
| 77 | ○ | ○ | ○ | ○ | ○ | ○ | ○ | 83 |
| 78 | ○ | ○ | ○ | ○ | ○ | ○ | ○ | 85 |
| 79 | ○ | ○ | ○ | ○ | ○ | ○ | ○ | 88 |

**[Table 59]**

| No. | Sensiti vity | Scum | Crack | Chemical resistan ce | Adhesio n force | OLED reliabi lity | Folding charact eristic | Imidiza tion rate |
|---|---|---|---|---|---|---|---|---|
| 80 | ○ | ○ | ○ | ○ | ○ | ○ | ○ | 87 |
| 81 | ○ | ○ | ○ | ○ | ○ | ○ | ○ | 89 |
| 82 | ○ | ○ | ○ | ○ | ○ | ○ | ○ | 75 |
| 83 | ○ | ○ | ○ | ○ | ○ | ○ | ○ | 71 |
| 84 | ○ | ○ | ○ | ○ | ○ | ○ | ○ | 69 |
| 85 | ○ | ○ | ○ | ○ | ○ | ○ | ○ | 72 |
| 86 | ○ | ○ | ○ | Δ | ○ | ○ | ○ | 89 |
| 87 | ○ | ○ | ○ | ○ | ○ | ○ | Δ | 88 |

Although the embodiments of the present disclosure have been described in detail above, the scope of the present disclosure is not limited thereto, and various modifications and variations are possible without departing from the technical spirit of the present disclosure described in the claims. It will be apparent to those of ordinary skill in the art.

## Claims

1. A positive photosensitive resin composition comprising:
an alkali-soluble polymer resin comprising repeating units represented by Chemical Formulae 1 and 2 below as a main chain;
a quinone diazide compound; and
a solvent; 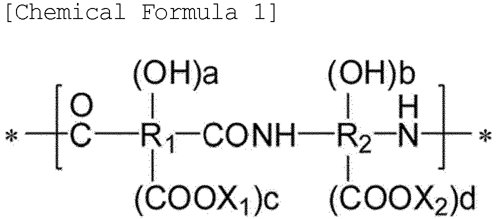 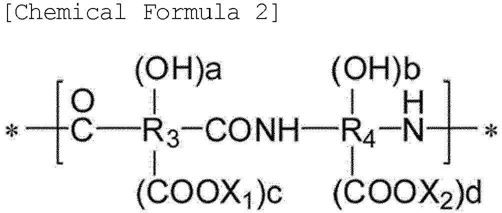
In the Chemical Formula 1 to 2,
the R₁, R₂, R₃, and R₄ are each independently an organic group having 5 to 60 carbon atoms,
the X₁ and X₂ are each independently hydrogen and an alkyl group having 1 to 10 carbon atoms,
a and b are each independently an integer in a range of 0 to 4, c and d are each independently an integer in a range of 0 to 2, a + b is 1 or more, and a corresponding substituent is H when a, b, c, or d is 0,
at least one of R₃ and R₄ has a structure represented by General Formula 1 below, and
5 to 70 mol% of 100 mol% of R₁ to R₄ comprises a structure represented by General Formula 1 below: 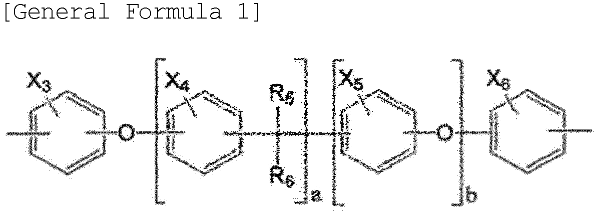
(In General Formula 1, a and b are each independently an integer in a range of 0 to 10,
the X₃ to X₆ are each independently hydrogen or a monovalent organic group having 1 to 5 carbon atoms,
the R₅ and R₆ are each independently a monovalent organic group having 1 to 10 carbon atoms.)

2. The composition of claim 1, wherein a and b in the General Formula 1 are each independently an integer in a range of 0 to 3.

3. The composition of claim 1, wherein the alkali-soluble polymer resin comprises repeating units represented by Chemical Formulae 1 to 4. 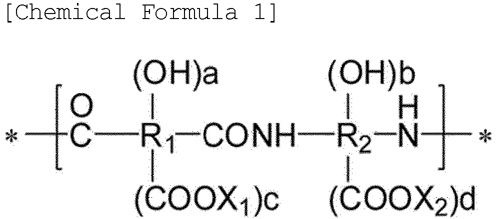 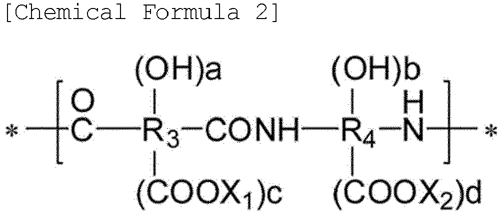 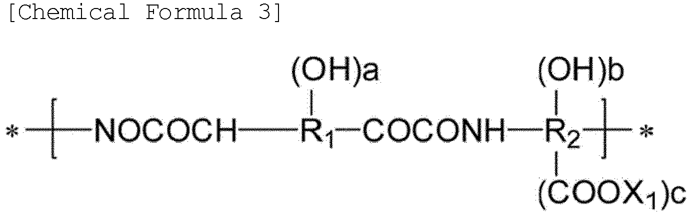 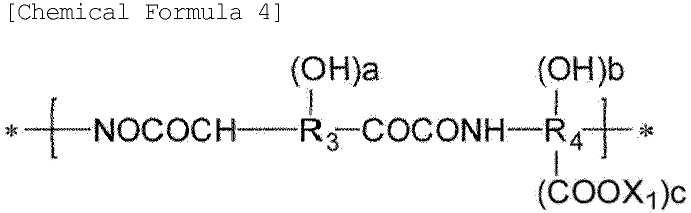 In the Chemical Formula 1 to 4,
the R₁, R₂, R₃, and R₄ are each independently an organic group having 5 to 60 carbon atoms,
the X₁ and X₂ are each independently hydrogen or an alkyl group having 1 to 10 carbon atoms,
a and b are each independently an integer in a range of 0 to 4, c and d are each independently an integer in a range of 0 to 2, a + b is 1 or more, and a corresponding substituent is H when a, b, c, or d is 0,
at least one of R₃ and R₄ comprises a structure represented by the following General Formula 1, and
5 to 70 mol% of 100 mol% of R₁ to R₄ comprises a structure represented by General Formula 1 below. 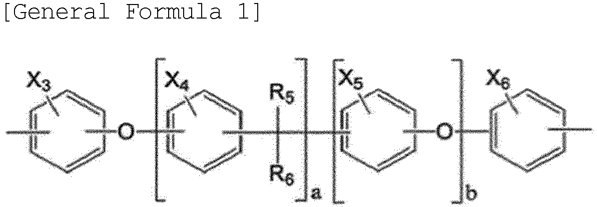
(In General Formula 1, a and b are each independently an integer in a range of 0 to 10,
the X₃ to X₆ are each independently hydrogen or a monovalent organic group having 1 to 5 carbon atoms,
the R₅ and R₆ are each independently a monovalent organic group having 1 to 10 carbon atoms.)

4. The composition of claim 3, wherein 51 mol% or more of 100 mol% of the repeating units represented by Chemical Formulae 1 to 4 comprised in the alkali-soluble polymer resin are repeating units represented by the Chemical Formulae 3 to 4.

5. The composition of claim 1, wherein 40 to 70 mol% of 100 mol% of R₁ to R₄ comprised in the repeating units represented by Chemical Formulae 1 to 4 comprised in the alkali-soluble polymer resin have a structure represented by the General Formula 1.

6. The composition of claim 1, comprising 5 to 50 parts by weight of the thermal cross-linking agent per 100 parts by weight of the alkali-soluble polymer resin, and 100 to 2,000 parts by weight of the solvent per 100 parts by weight of the alkali-soluble polymer resin.

7. The composition of claim 1, wherein R₃ and R₄ in the alkali-soluble polymer resin comprise a structure represented by the General Formula 1.

8. The composition of claim 1, wherein the R₄ is a structure derived from any one of the structures represented by Chemical Formulae 5 to 14 below, and the R₃ is a structure derived from any one of the structures represented by Chemical Formulae 15 to 21 below:

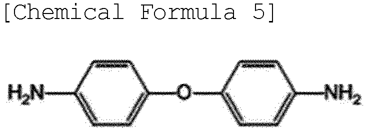

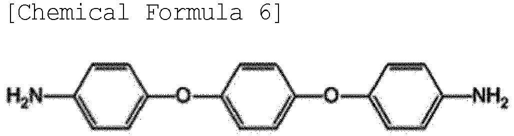

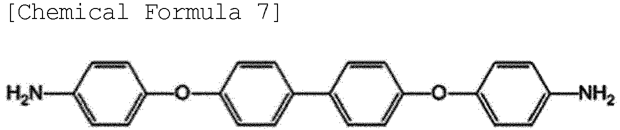

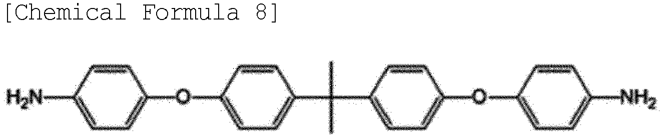

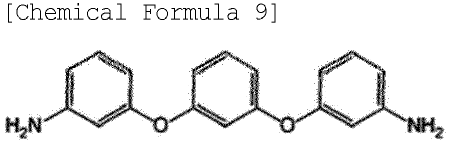

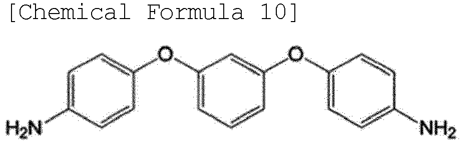

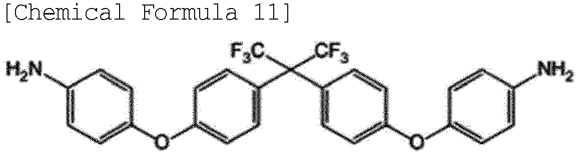

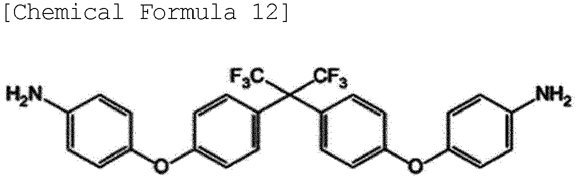

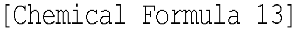

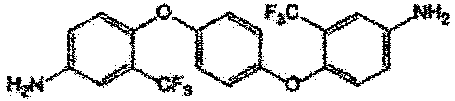

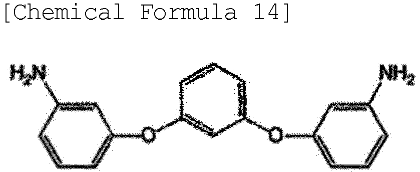

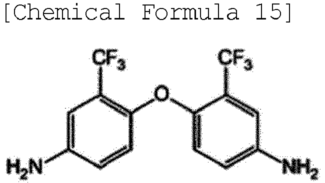

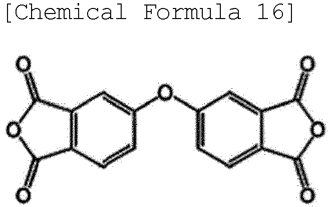

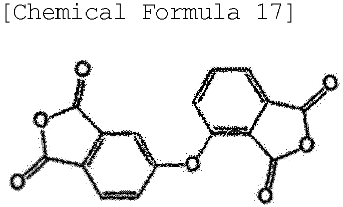

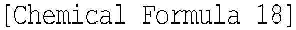

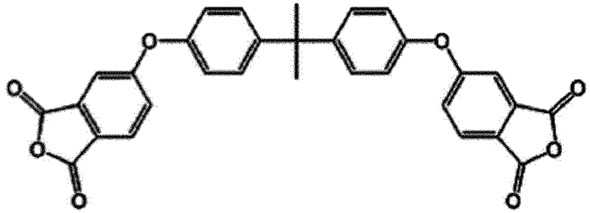

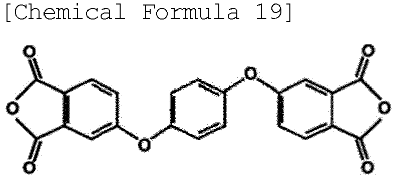

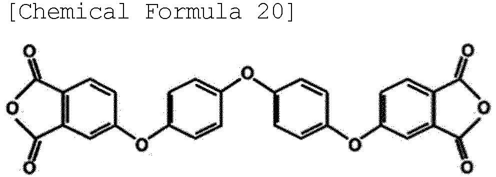

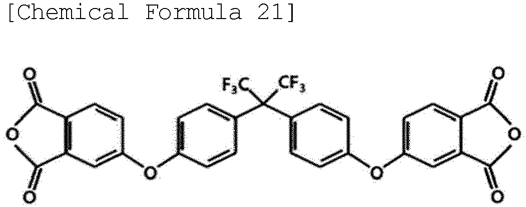

9. The composition of claim 1, wherein the quinone diazide compound is obtained by reacting a naphthoquinone diazide sulfonic acid halogen compound with a phenolic compound selected from the group consisting of compounds represented by Chemical Formulae a to h: 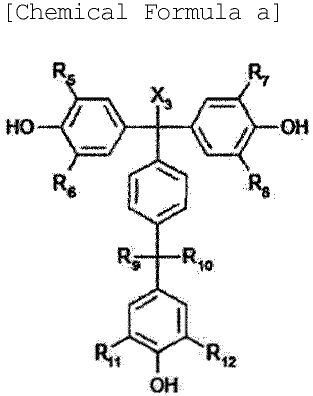 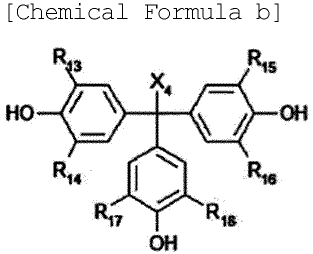 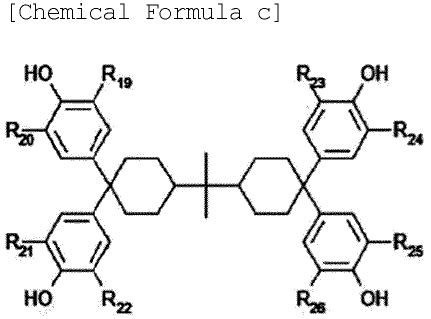 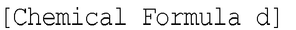 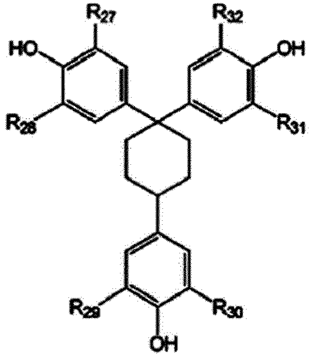 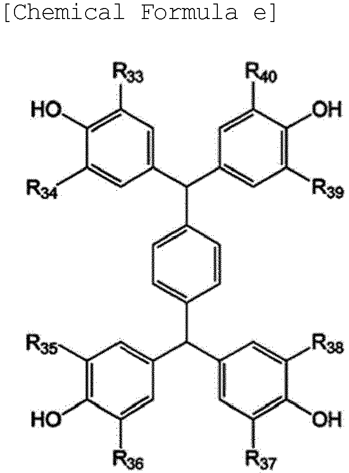 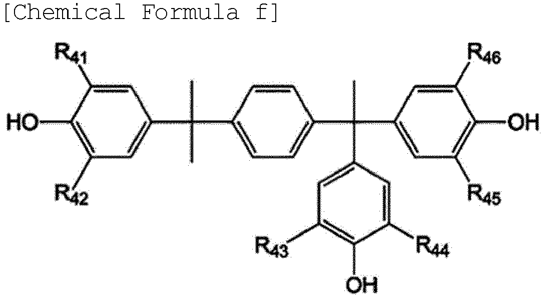 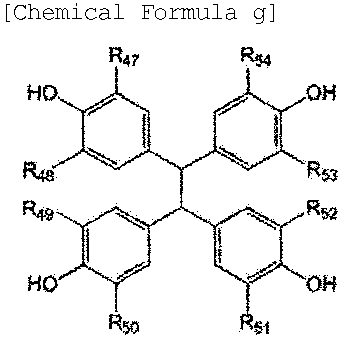 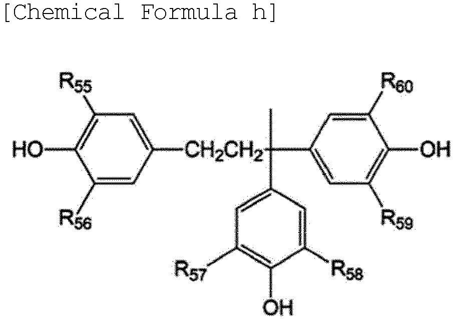
(In the Chemical Formula a to Chemical Formula h, the R₅ to R₈ and the R₁₁ to R₆₀ are each independently hydrogen, halogen, a hydroxyl group, an alkyl group having 1 to 4 carbon atoms, or an alkenyl group having 2 to 4 carbon atoms,
the X₃ and X₄ are each independently hydrogen, halogen, or an alkyl group having 1 to 4 carbon atoms,
the R₉ and R₁₀ are each independently hydrogen or an alkyl group having 1 to 4 carbon atoms.)

10. The composition of claim 1, wherein the solvent is any one selected from the group consisting of gamma-butyrolactone (GBL), N-methylpyrrolidone (NMP), propyleneglycolmethylether acetate (PGMEA), ethyl lactate (EL), methyl-3-methoxypropionate (MMP), propyleneglycolmonomethyl ether (PGME), diethylglycolethylmethyl ether (MEDG), diethylglycolbutylmethyl ether (MBDG), diethyleneglycoldimethyl ester (DMDG), diethyleneglycoldiethyl ester (DEDG), and a mixture thereof.

11. The composition of claim 1, further comprising a thermal cross-linking agent having a functional group represented by Chemical Formula 22: 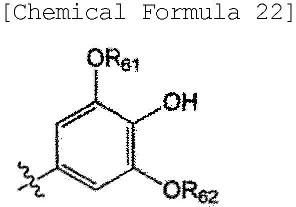 (In the Chemical Formula 22, R₆₁ and R₆₂ are each independently a monovalent organic group having 1 to 5 carbon atoms.)

12. The composition of claim 11, wherein the thermal cross-linking agent is any one of the compounds represented by Chemical Formulae i to n. 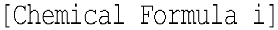 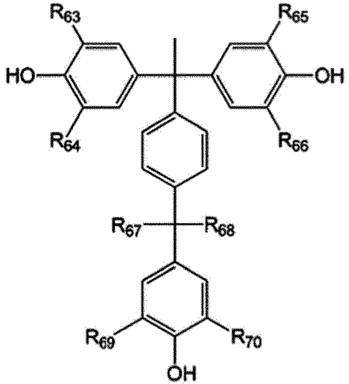 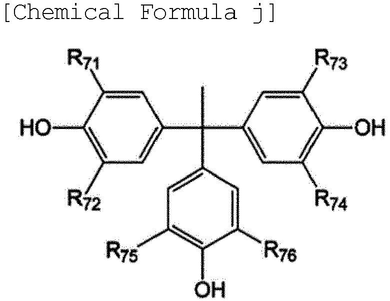 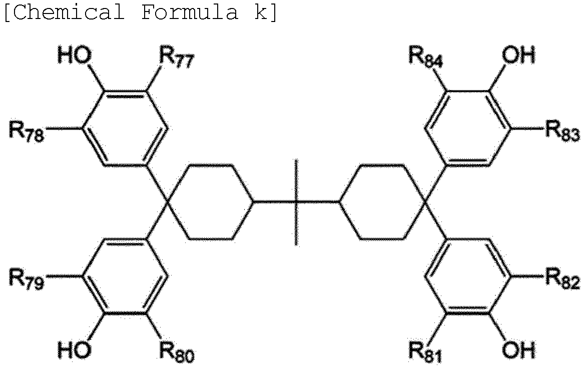 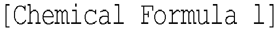 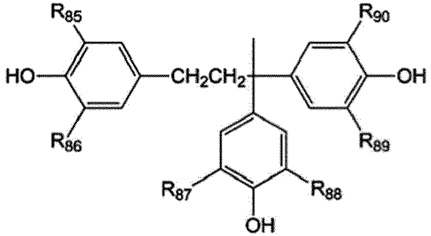 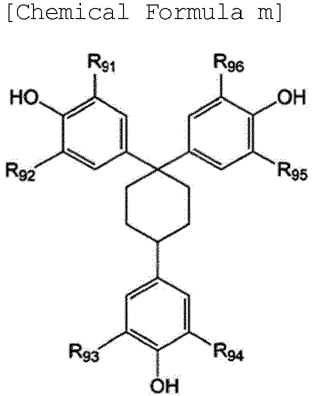 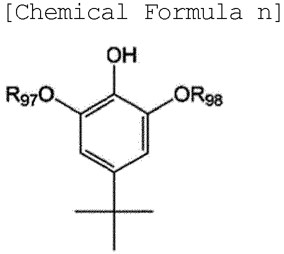 (In the Chemical Formulae i to n, R₆₃ to R₉₈ are each independently a monovalent organic group having 1 to 5 carbon atoms.)

13. The composition of claim 11, wherein 5 to 50 parts by weight of the thermal cross-linking agent is included based on 100 parts by weight of the alkali-soluble polymer resin.

14. A cured body of the photosensitive resin composition of any one of claims 1 to 13.

15. The cured body of claim 14, wherein the cured body is folded with a curvature radius of 1R size or less at a thickness of 3 pm.

16. The cured body of claim 14, wherein the cured body does not generate cracks after 200,000 times of in-folding with a radius of curvature of 1R at a thickness of 3 pm.

17. A display device comprising the cured body of claim 14 as an insulating layer.

18. The cured body of claim 17, wherein the display device is a flexible display device.

19. A semiconductor package device comprising the cured body of claim 14 as an insulating layer.
